(19)

Europäisches Patentamt

European Patent Office

Office européen des brevets

(11) **EP 4 531 287 A1**

(12) **EUROPEAN PATENT APPLICATION**
published in accordance with Art. 153(4) EPC

(43) Date of publication:
**02.04.2025 Bulletin 2025/14**

(21) Application number: **23810762.7**

(22) Date of filing: **28.04.2023**

(51) International Patent Classification (IPC):
***H03M 13/13*** (2006.01)

(52) Cooperative Patent Classification (CPC):
**H03M 13/13; H04L 1/00**

(86) International application number:
**PCT/CN2023/091491**

(87) International publication number:
**WO 2023/226689 (30.11.2023 Gazette 2023/48)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **23.05.2022 CN 202210566961**

(71) Applicant: **Huawei Technologies Co., Ltd.**
**Shenzhen, Guangdong 518129 (CN)**

(72) Inventors:
• **WANG, Xianbin**
**Shenzhen, Guangdong 518129 (CN)**

• **ZHANG, Huazi**
**Shenzhen, Guangdong 518129 (CN)**
• **QIN, Kangjian**
**Shenzhen, Guangdong 518129 (CN)**
• **TONG, Jiajie**
**Shenzhen, Guangdong 518129 (CN)**
• **LI, Rong**
**Shenzhen, Guangdong 518129 (CN)**
• **WANG, Jun**
**Shenzhen, Guangdong 518129 (CN)**

(74) Representative: **Gill Jennings & Every LLP**
**The Broadgate Tower**
**20 Primrose Street**
**London EC2A 2ES (GB)**

(54) **ENCODING METHOD AND APPARATUS, AND DECODING METHOD AND APPARATUS**

(57)    This application relates to the field of communication technologies, and discloses an encoding method, a decoding method, and an apparatus. Through introduction of bit position mapping, a systematic bit position and a frozen bit position of a systematic polar code can be decoupled, to bring larger encoding design space, and reduce encoding complexity of the systematic polar code. The method includes: obtaining an information bit sequence; and encoding the information bit sequence based on a systematic polar code, to determine an encoded bit sequence, where the systematic polar code includes N first bit positions and N second bit positions that correspond to a polarization transformation matrix, the N second bit positions include a systematic bit position set A and a non-systematic bit position set $M^A$, the N first bit positions include a frozen bit position set B and a non-frozen bit position set $M^B$, there is a subset C in B, there is a subset D in $M^B$, a bit position in C and a bit position in D are mapped to each other, C is determined based on a bit position index intersection set of B and A, D is determined based on a bit position index intersection set of $M^B$ and $M^A$, and A is determined based on the information bit sequence.

FIG. 7

EP 4 531 287 A1

# Description

## CROSS-REFERENCE TO RELATED APPLICATIONS

This application claims priority to Chinese Patent Application No. 202210566961.3, filed with the China National Intellectual Property Administration on May 23, 2022 and entitled "ENCODING METHOD, DECODING METHOD, AND APPARATUS", which is incorporated herein by reference in its entirety.

## TECHNICAL FIELD

Embodiments of this application relate to the field of communication technologies, and in particular, to an encoding method, a decoding method, and an apparatus.

## BACKGROUND

In a 5th generation (5th generation, 5G) mobile communication system, there are three most typical communication scenarios: enhanced mobile broadband (enhanced mobile broadband, eMBB), massive machine-type communications (massive machine-type communications, mMTC), and ultra-reliable and low-latency communication (ultra-reliable and low-latency communication, URLLC). As a basic radio access technology, channel encoding is one of important research objects that meet 5G communication requirements. A polar code (polar code) is selected as a control encoding solution in a 5G standard. The polar code may also be referred to as a polar code, and is a first and uniquely known channel encoding solution that can be strictly proved to "reach" a Shannon channel capacity. For different code lengths, particularly for limited codes, performance of the polar code is much better than that of a turbo code and a low-density parity-check (low-density parity-check, LDPC) code. In addition, the polar code has low computational complexity in encoding and decoding. These advantages enable the polar code to have great development and application prospects in 5G.

A systematic polar code is a polar code whose information bits are directly carried at systematic bit positions on a codeword side. Compared with a non-systematic polar code, the systematic polar code has better bit error ratio (bit error ratio, BER) performance, is more convenient to be concatenated with another code, is widely applied (for example, can be used for joint source-channel coding (joint source-channel coding, JSCC)), and has other advantages. However, during encoding of an existing systematic polar code, because a position relationship between a systematic bit position and a frozen bit position is mutual coupling, an encoding process needs to be serially performed or a non-systematic polar code encoding process needs to be performed in parallel for a plurality of times. Consequently, there are problems of high encoding complexity and limited encoding flexibility.

## SUMMARY

Embodiments of this application provide an encoding method, a decoding method, and an apparatus. Through introduction of bit position mapping, a systematic bit position and a frozen bit position of a systematic polar code can be decoupled, to bring larger encoding design space, reduce encoding complexity, and improve encoding flexibility.

According to a first aspect, an embodiment of this application provides an encoding method. The method includes: obtaining an information bit sequence; encoding the information bit sequence based on a systematic polar code, to determine an encoded bit sequence, where the systematic polar code includes a polarization transformation matrix and N first bit positions and N second bit positions that correspond to the polarization transformation matrix, the N second bit positions include a systematic bit position set A and a non-systematic bit position set $M^A$, the N first bit positions include a frozen bit position set B and a non-frozen bit position set $M^B$, there is a frozen bit position subset C in B, there is a non-frozen bit position subset D in $M^B$, a frozen bit position in C and a non-frozen bit position in D are mapped to each other, C is determined based on a bit position index intersection set of B and A, D is determined based on a bit position index intersection set of $M^B$ and $M^A$, A is determined based on the information bit sequence, and the encoded bit sequence includes the information bit sequence; and outputting the encoded bit sequence.

The encoding method may be performed by an encoding device such as a network device or a terminal device, may be performed by a component (for example, a processor, a chip, or a chip system) of the encoding device, or may be implemented by a logic module or software that can implement all or some functions of the encoding device.

In addition, it should be understood that, for the systematic polar code, systematic bit positions may be used to carry the information bit sequence, and a total quantity of systematic bit positions and frozen bit positions is equal to a code length N of the systematic polar code. Therefore, in this embodiment of this application, A may be determined based on the information bit sequence. For example, if a length of the information bit sequence is K, A includes K systematic bit positions, B includes N-K frozen bit positions, $M^A$ includes N-K non-systematic bit positions, and $M^B$ includes K non-frozen bit positions.

According to the foregoing method, a mutual mapping relationship between the frozen bit position in C and the non-frozen bit position in D is introduced (for example, a value of the frozen bit position in C one to one corresponds to and is the same as a value of the bit position in D). During encoding, the value of the non-frozen bit position (namely, a bit carried at the non-frozen bit position) in D may be determined based on the value of the frozen bit position (namely, a bit carried at the frozen bit position) in C. During decoding, the value of the frozen bit position in C may be determined based on the value of the non-frozen bit position in D, so that bit position indexes of frozen bit positions and bit position indexes of systematic bit positions of the systematic polar code may overlap, and the systematic bit position and the frozen bit position of the systematic polar code are decoupled, thereby bringing larger encoding design space, reducing encoding complexity, and improving encoding flexibility.

For example, for a systematic polar code whose code length is 8, a mutual mapping relationship between a frozen bit position whose bit position index is 4 and a non-frozen bit position whose bit position index is 3 is introduced. Bit position indexes of the frozen bit positions may be 0, 1, 2, and 4, and bit position indexes of systematic bit positions may be 4, 5, 6, and 7. In an encoding process, a value of the non-frozen bit position whose bit position index is 3 may be determined based on a value of the frozen bit position whose bit position index is 4. An encoding issue that the systematic polar code whose code length is 8 corresponds to bit position indexes 0, 1, 2, 3, 4, 5, 6, and 7 may be split into two sub-encoding issues that the systematic polar code whose code length is 8 corresponds to bit position indexes 0, 1, 2, and 3 and corresponds to bit position indexes 4, 5, 6, and 7. Parallel encoding may be performed on each sub-encoding issue, and encoding complexity is equivalent to that of performing a non-systematic polar code encoding process once. This can reduce encoding complexity, is applicable to a plurality of systematic bit position setting manners, and can improve encoding flexibility.

Optionally, that the frozen bit position in C and the non-frozen bit position in D are mapped to each other includes: the frozen bit position in C and the non-frozen bit position in D are mapped to each other based on a mapping matrix, where the mapping matrix is an $N_C$-dimensional full-rank matrix or an $N_C$-dimensional identity matrix, and $N_C$ is equal to a quantity of frozen bit positions in C.

In a possible design, the encoding the information bit sequence based on a systematic polar code, to determine the encoded bit sequence includes: determining a first intermediate encoded bit sequence based on the information bit sequence and a first polarization transformation submatrix, where the first polarization transformation submatrix is a polarization transformation submatrix that corresponds to A and that is in the polarization transformation matrix; determining a second intermediate encoded bit sequence based on the first intermediate encoded bit sequence, a mutual mapping relationship between the frozen bit position in C and the non-frozen bit position in D, and a bit position index intersection set of B and $M^A$, where a length of the second intermediate encoded bit sequence is equal to a quantity of second bit positions included in $M^A$; and determining the encoded bit sequence based on the second intermediate encoded bit sequence, a second polarization transformation submatrix, and the information bit sequence, where the second polarization transformation submatrix is a polarization transformation submatrix that corresponds to $M^A$ and that is in the polarization transformation matrix.

According to the foregoing method, an encoding issue that the systematic polar code whose code length is N corresponds to bit position indexes 0, 1, ..., and N may be split into two sub-encoding issues that the systematic polar code whose code length is N corresponds to bit position indexes of A and corresponds to bit position indexes of $M^A$. Parallel encoding is performed on each sub-encoding issue, and encoding complexity is equivalent to that of performing a non-systematic polar code encoding process once, so that encoding complexity can be reduced.

In a possible design, A includes last K second bit positions in the N second bit positions; and/or B includes N-K first bit positions selected from the N first bit positions based on channel reliability or codeword weights, where K is greater than or equal to 1 and less than N. For example, B may include N-K first bit positions that have lowest channel reliability and that are selected from the N first bit positions based on the channel reliability, or include N-K first bit positions that have lowest codeword weights and that are selected from the N first bit positions based on the codeword weights.

In the design, the last K second bit positions in the N second bit positions are directly used as the systematic bit positions, so that an encoding process can be simplified and encoding efficiency can be improved.

In a possible design, the systematic polar code is concatenated with a precoding matrix, and the precoding matrix is an upper triangular matrix $\begin{bmatrix} TA & TB \\ 0 & TC \end{bmatrix}$, where a quantity of rows of $TA$ and a quantity of rows of $TB$ are determined based on a quantity of non-systematic bit positions in $M^A$, a quantity of rows of $TC$ is determined based on a quantity of systematic bit positions in A, a quantity of columns of $TA$ is determined based on the quantity of non-systematic bit positions in $M^A$, and a quantity of columns of $TB$ and a quantity of columns of $TC$ are determined based on the quantity of systematic bit positions in A.

The encoding the information bit sequence based on a systematic polar code, to determine the encoded bit sequence includes: determining the first intermediate encoded bit sequence based on the information bit sequence and the first polarization transformation submatrix, where the first polarization transformation submatrix is the polarization transformation submatrix that corresponds to A and that is in the polarization transformation matrix; determining a third intermediate encoded bit sequence based on the first intermediate encoded bit sequence, $TC$, and $TB$; determining a fourth intermediate encoded bit sequence based on the third intermediate encoded bit sequence, the mutual mapping relationship between the frozen bit position in C and the non-frozen bit position in D, and the bit position index intersection set of B and $M^A$; determining the second intermediate encoded bit sequence based on the fourth intermediate encoded bit sequence and $TA$; and determining the encoded bit sequence based on the second intermediate encoded bit sequence, the second polarization transformation submatrix, and the information bit sequence, where the second polarization transformation submatrix is the polarization transformation submatrix that corresponds to $M^A$ and that is in the polarization transformation matrix.

In the design, the precoding matrix is concatenated, and a code spectrum of the systematic polar code may be optimized, to improve performance of the systematic polar code.

In a possible design, that A is determined based on the information bit sequence includes: A includes a position of an information bit and a position of a cyclic redundancy check (cyclic redundancy check, CRC) bit corresponding to the information bit.

In the design, the CRC bit corresponding to the information bit is set, so that an error correction capability of decoding can be improved, decoding reliability can be improved, and implementation is simple.

In a possible design, the first intermediate encoded bit sequence includes a fifth intermediate encoded bit sequence and the CRC bit, the fifth intermediate encoded bit sequence is determined based on the information bit sequence and the first polarization transformation submatrix, and the CRC bit is determined based on the fifth intermediate encoded bit sequence.

In the design, the CRC bit is set on a to-be-encoded side (namely, a non-codeword side) of the systematic polar code, and a check relationship is formed between the CRC bit and the encoded bit sequence on the to-be-encoded side, thereby facilitating early stop of decoding.

In a possible design, the first intermediate encoded bit sequence includes a fifth intermediate encoded bit sequence and the CRC bit, the fifth intermediate encoded bit sequence is determined based on the information bit sequence and the first polarization transformation submatrix, and the CRC bit is determined based on the information bit sequence.

In the design, the CRC bit corresponding to the information bit is set, so that an error correction capability of decoding can be improved, and decoding reliability can be improved.

According to a second aspect, an embodiment of this application provides a decoding method. The method includes: obtaining a to-be-decoded symbol sequence; and decoding the to-be-decoded symbol sequence based on a systematic polar code, to determine an information bit sequence, where the systematic polar code includes a polarization transformation matrix and N first bit positions and N second bit positions that correspond to the polarization transformation matrix, the N second bit positions include a systematic bit position set A and a non-systematic bit position set $M^A$, the N first bit positions include a frozen bit position set B and a non-frozen bit position set $M^B$, there is a frozen bit position subset C in B, there is a non-frozen bit position subset D in $M^B$, a frozen bit position in C and a non-frozen bit position in D are mapped to each other, C is determined based on a bit position index intersection set of B and A, D is determined based on a bit position index intersection set of $M^B$ and $M^A$, and A is determined based on the information bit sequence.

The decoding method may be performed by a decoding device such as a network device or a terminal device, may be performed by a component (for example, a processor, a chip, or a chip system) of the decoding device, or may be implemented by a logic module or software that can implement all or some functions of the decoding device.

In addition, it should be understood that, for the systematic polar code, systematic bit positions may be used to carry the information bit sequence, and a total quantity of systematic bit positions and frozen bit positions is equal to a code length N of the systematic polar code. Therefore, in this embodiment of this application, A may be determined based on the information bit sequence. For example, if a length of the information bit sequence is K, A includes K systematic bit positions, B includes N-K frozen bit positions, $M^A$ includes N-K non-systematic bit positions, and $M^B$ includes K non-frozen bit positions.

Optionally, that the frozen bit position in C and the non-frozen bit position in D are mapped to each other includes: the frozen bit position in C and the non-frozen bit position in D are mapped to each other based on a mapping matrix, where the mapping matrix is an $N_C$-dimensional full-rank matrix or an $N_C$-dimensional identity matrix, and $N_C$ is equal to a quantity of frozen bit positions in C.

In a possible design, the decoding the to-be-decoded symbol sequence based on a systematic polar code, to determine an information bit sequence includes: determining a first intermediate decoded bit sequence based on the to-be-decoded symbol sequence, the polarization transformation matrix, a mutual mapping relationship between the frozen bit position in C and the non-frozen bit position in D, and a bit position index intersection set of B and $M^A$; and determining the information bit sequence based on the first intermediate decoded bit sequence and the polarization transformation matrix.

In a possible design, A includes last K second bit positions in the N second bit positions; and/or B includes N-K first bit positions selected from the N first bit positions based on channel reliability or codeword weights, where K is greater than or equal to 1 and less than N.

In a possible design, that A is determined based on the information bit sequence includes: A includes a position of an information bit and a position of a CRC bit corresponding to the information bit.

In a possible design, the first intermediate decoded bit sequence includes a second intermediate decoded bit sequence and the CRC bit, the CRC bit is used to check the second intermediate decoded bit sequence, the second intermediate decoded bit sequence corresponds to the position of the information bit, and the CRC bit corresponds to the position of the CRC bit.

In a possible design, the first intermediate decoded bit sequence includes a second intermediate decoded bit sequence and the CRC bit, the CRC bit is used to check the information bit sequence, the second intermediate decoded bit sequence corresponds to the position of the information bit, and the CRC bit corresponds to the position of the CRC bit.

According to a third aspect, an embodiment of this application provides a communication apparatus. The communication apparatus may include: an input/output unit and a processing unit. The input/output unit is configured to obtain an information bit sequence; the processing unit is configured to encode the information bit sequence based on a systematic polar code, to determine an encoded bit sequence, where the systematic polar code includes a polarization transformation matrix and N first bit positions and N second bit positions that correspond to the polarization transformation matrix, the N second bit positions include a systematic bit position set A and a non-systematic bit position set $M^A$, the N first bit positions include a frozen bit position set B and a non-frozen bit position set $M^B$, there is a frozen bit position subset C in B, there is a non-frozen bit position subset D in $M^B$, a frozen bit position in C and a non-frozen bit position in D are mapped to each other, C is determined based on a bit position index intersection set of B and A, D is determined based on a bit position index intersection set of $M^B$ and $M^A$, A is determined based on the information bit sequence, and the encoded bit sequence includes the information bit sequence; and the input/output unit is further configured to output the encoded bit sequence.

Optionally, that the frozen bit position in C and the non-frozen bit position in D are mapped to each other includes: the frozen bit position in C and the non-frozen bit position in D are mapped to each other based on a mapping matrix, where the mapping matrix is an $N_C$-dimensional full-rank matrix or an $N_C$-dimensional identity matrix, and $N_C$ is equal to a quantity of frozen bit positions in C.

In a possible design, when encoding the information bit sequence based on the systematic polar code to determine the encoded bit sequence, the processing unit is specifically configured to determine a first intermediate encoded bit sequence based on the information bit sequence and a first polarization transformation submatrix, where the first polarization transformation submatrix is a polarization transformation submatrix that corresponds to A and that is in the polarization transformation matrix; determine a second intermediate encoded bit sequence based on the first intermediate encoded bit sequence, a mutual mapping relationship between the frozen bit position in C and the non-frozen bit position in D, and a bit position index intersection set of B and $M^A$, where a length of the second intermediate encoded bit sequence is equal to a quantity of second bit positions included in $M^A$; and determine the encoded bit sequence based on the second intermediate encoded bit sequence, a second polarization transformation submatrix, and the information bit sequence, where the second polarization transformation submatrix is a polarization transformation submatrix that corresponds to $M^A$ and that is in the polarization transformation matrix.

In a possible design, A includes last K second bit positions in the N second bit positions; and/or B includes N-K first bit positions selected from the N first bit positions based on channel reliability or codeword weights, where K is greater than or equal to 1 and less than N.

In a possible design, the systematic polar code is concatenated with a precoding matrix, and the precoding matrix is an upper triangular matrix $\begin{bmatrix} TA & TB \\ 0 & TC \end{bmatrix}$, where a quantity of rows of $TA$ and a quantity of rows of $TB$ are determined based on a quantity of non-systematic bit positions in $M^A$, a quantity of rows of $TC$ is determined based on a quantity of systematic bit positions in A, a quantity of columns of $TA$ is determined based on the quantity of non-systematic bit positions in $M^A$, and a quantity of columns of $TB$ and a quantity of columns of $TC$ are determined based on the quantity of systematic bit positions in A.

When encoding the information bit sequence based on the systematic polar code to determine the encoded bit sequence, the processing unit is specifically configured to determine the first intermediate encoded bit sequence based on the information bit sequence and the first polarization transformation submatrix, where the first polarization transformation submatrix is the polarization transformation submatrix that corresponds to A and that is in the polarization transformation matrix; determine a third intermediate encoded bit sequence based on the first intermediate encoded bit sequence, $TC$, and $TB$; determine a fourth intermediate encoded bit sequence based on the third intermediate encoded bit sequence, the mutual mapping relationship between the frozen bit position in C and the non-frozen bit position in D, and the bit position index intersection set of B and $M^A$; determine the second intermediate encoded bit sequence based on the fourth intermediate encoded bit sequence and $TA$; and determine the encoded bit sequence based on the second intermediate encoded bit sequence, the second polarization transformation submatrix, and the information bit sequence, where the second polarization transformation submatrix is the polarization transformation submatrix that corresponds to $M^A$ and that is in the polarization transformation matrix.

In a possible design, that A is determined based on the information bit sequence includes: A includes a position of an information bit and a position of a CRC bit corresponding to the information bit.

In a possible design, the first intermediate encoded bit sequence includes a fifth intermediate encoded bit sequence and the CRC bit, the fifth intermediate encoded bit sequence is determined based on the information bit sequence and the first polarization transformation submatrix, and the CRC bit is determined based on the fifth intermediate encoded bit sequence.

In a possible design, the first intermediate encoded bit sequence includes a fifth intermediate encoded bit sequence and the CRC bit, the fifth intermediate encoded bit sequence is determined based on the information bit sequence and the first polarization transformation submatrix, and the CRC bit is determined based on the information bit sequence.

According to a fourth aspect, an embodiment of this application provides a communication apparatus. The communication apparatus may include: an input/output unit and a processing unit. The input/output unit is configured to obtain a to-be-decoded symbol sequence; and the processing unit is configured to decode the to-be-decoded symbol sequence based on a systematic polar code, to determine an information bit sequence, where the systematic polar code includes a polarization transformation matrix and N first bit positions and N second bit positions that correspond to the polarization transformation matrix, the N second bit positions include a systematic bit position set A and a non-systematic bit position set $M^A$, the N first bit positions include a frozen bit position set B and a non-frozen bit position set $M^B$, there is a frozen bit position subset C in B, there is a non-frozen bit position subset D in $M^B$, a frozen bit position in C and a non-frozen bit position in D are mapped to each other, C is determined based on a bit position index intersection set of B and A, D is determined based on a bit position index intersection set of $M^B$ and $M^A$, and A is determined based on the information bit sequence.

Optionally, that the frozen bit position in C and the non-frozen bit position in D are mapped to each other includes: the frozen bit position in C and the non-frozen bit position in D are mapped to each other based on a mapping matrix, where the mapping matrix is an $N_C$-dimensional full-rank matrix or an $N_C$-dimensional identity matrix, and $N_C$ is equal to a quantity of frozen bit positions in C.

In a possible design, when decoding the to-be-decoded symbol sequence based on the systematic polar code to determine the information bit sequence, the processing unit is specifically configured to determine a first intermediate decoded bit sequence based on the to-be-decoded symbol sequence, the polarization transformation matrix, a mutual mapping relationship between the frozen bit position in C and the non-frozen bit position in D, and a bit position index intersection set of B and $M^A$; and determine the information bit sequence based on the first intermediate decoded bit sequence and the polarization transformation matrix.

In a possible design, A includes last K second bit positions in the N second bit positions; and/or B includes N-K first bit positions selected from the N first bit positions based on channel reliability or codeword weights, where K is greater than or equal to 1 and less than N.

In a possible design, that A is determined based on the information bit sequence includes: A includes a position of an information bit and a position of a CRC bit corresponding to the information bit.

In a possible design, the first intermediate decoded bit sequence includes a second intermediate decoded bit sequence and the CRC bit, the CRC bit is used to check the second intermediate decoded bit sequence, the second intermediate decoded bit sequence corresponds to the position of the information bit, and the CRC bit corresponds to the position of the CRC bit.

In a possible design, the first intermediate decoded bit sequence includes a second intermediate decoded bit sequence and the CRC bit, the CRC bit is used to check the information bit sequence, the second intermediate decoded bit sequence corresponds to the position of the information bit, and the CRC bit corresponds to the position of the CRC bit.

According to a fifth aspect, an embodiment of this application provides a communication apparatus. The communication apparatus includes an interface circuit and a processor, and the processor and the interface circuit are coupled to each other. The processor is configured to implement the method according to any one of the first aspect or the possible designs of the first aspect through a logic circuit or by executing code instructions. The interface circuit is configured to receive a signal from a communication apparatus other than the communication apparatus and sned the signal to the processor, or send a signal from the processor to a communication apparatus other than the communication apparatus. It can be understood that the interface circuit may be a transceiver, a transceiver machine, a transceiver, or an input/output interface.

Optionally, the communication apparatus may further include a memory, configured to store instructions executed by the processor, store input data needed by the processor to run the instructions, or store data generated after the processor runs the instructions. The memory may be a physically independent unit, or may be coupled to the processor, or the processor includes the memory.

According to a sixth aspect, an embodiment of this application provides a communication apparatus. The communication apparatus includes an interface circuit and a processor, and the processor and the interface circuit are coupled to each other. The processor is configured to implement the method according to any one of the second aspect or the possible designs of the second aspect through a logic circuit or by executing code instructions. The interface circuit is configured to receive a signal from a communication apparatus other than the communication apparatus and send the signal to the processor, or send a signal from the processor to a communication apparatus other than the communication apparatus. It can be understood that the interface circuit may be a transceiver, a transceiver machine, a transceiver, or an input/output interface.

Optionally, the communication apparatus may further include a memory, configured to store instructions executed by the processor, store input data needed by the processor to run the instructions, or store data generated after the processor runs the instructions. The memory may be a physically independent unit, or may be coupled to the processor, or the processor includes the memory.

According to a seventh aspect, an embodiment of this application provides a communication system. The communication system includes an encoding device and a decoding device. The encoding device may implement the method according to any one of the first aspect or the possible designs of the first aspect, and the decoding device may implement the method according to any one of the second aspect or the possible designs of the second aspect.

According to an eighth aspect, an embodiment of this application provides a computer-readable storage medium. The storage medium stores a computer program or instructions. When the computer program or the instructions are executed, the method according to any one of the first aspect or the possible designs of the first aspect, or the method according to any one of the second aspect or the possible designs of the second aspect may be implemented.

According to a ninth aspect, an embodiment of this application further provides a computer program product, including a computer program or instructions. When the computer program or the instructions are executed, the method according to any one of the first aspect or the possible designs of the first aspect or the method according to any one of the second aspect or the possible designs of the second aspect may be implemented.

According to a tenth aspect, an embodiment of this application further provides a chip. The chip is coupled to a memory, and is configured to read and execute a program or instructions stored in the memory, to implement the method according to any one of the first aspect or the possible designs of the first aspect, or implement the method according to any one of the second aspect or the possible designs of the second aspect.

For technical effects that can be achieved in the second aspect to the tenth aspect, refer to technical effects that can be achieved in the first aspect. Details are not described herein again.

## BRIEF DESCRIPTION OF DRAWINGS

FIG. 1 is a diagram of an architecture of a communication system according to an embodiment of this application;

FIG. 2 is a diagram of an encoding and decoding procedure according to an embodiment of this application;

FIG. 3 is a diagram of an encoding process according to an embodiment of this application;

FIG. 4 is a diagram of a decoding path in an SCL algorithm according to an embodiment of this application;

FIG. 5 is a first diagram of a systematic polar code according to an embodiment of this application;

FIG. 6 is a diagram of performing parallel encoding on a systematic polar code according to an embodiment of this application;

FIG. 7 is a diagram of an encoding and decoding method according to an embodiment of this application;

FIG. 8 is a second diagram of a systematic polar code according to an embodiment of this application;

FIG. 9 is a first diagram of a systematic polar code encoding process according to an embodiment of this application;

FIG. 10 is a diagram of pre-transforming a systematic polar code according to an embodiment of this application;

FIG. 11 is a diagram of a precoding matrix according to an embodiment of this application;

FIG. 12 is a second diagram of a systematic polar code encoding process according to an embodiment of this application;

FIG. 13 is a diagram of a systematic polar code decoding process according to an embodiment of this application;

FIG. 14 is a first diagram of a check bit carried in a systematic polar code according to an embodiment of this application;

FIG. 15 is a second diagram of a check bit carried in a systematic polar code according to an embodiment of this application;

FIG. 16 is a third diagram of a check bit carried in a systematic polar code according to an embodiment of this application;

FIG. 17 is a first diagram of a communication apparatus according to an embodiment of this application; and

FIG. 18 is a second diagram of a communication apparatus according to an embodiment of this application.

## DESCRIPTION OF EMBODIMENTS

Technical solutions of embodiments of this application may be applied to various communication systems, for example, a global system for mobile communications (global system for mobile communications, GSM) system, an enhanced data rate for GSM evolution (enhanced data rate for GSM evolution, EDGE) system, a wideband code division multiple access (wideband code division multiple access, WCDMA) system, a time division-synchronization code division multiple access (time division-synchronization code division multiple access, TD-SCDMA) system, a long term evolution (long term evolution, LTE) system, a worldwide interoperability for microwave access (worldwide interoperability for microwave access, WiMAX) communication system, and a 5th generation (5th generation, 5G) mobile communication system, for example, a new radio (new radio, NR) system. The technical solutions provided in this application may be further applied to a future communication system, for example, a 6th generation mobile communication system. Alternatively, the communication system may be a Bluetooth (Bluetooth) communication system, a wireless local area network (wireless local area network, WLAN)/wireless communication technology (Wi-Fi) communication system, a narrowband internet of things (narrowband internet of things, NB-IoT) communication system, or the like.

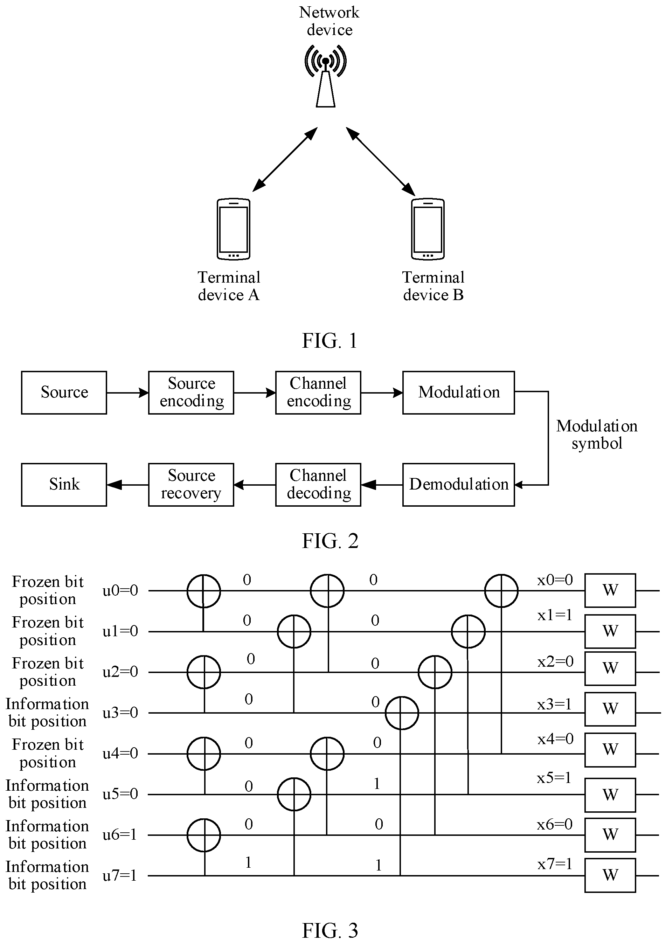

FIG. 1 is a diagram of an architecture of a communication system to which an embodiment of this application is applied. As shown in FIG. 1, the communication system includes a network device and a terminal device. For example, there is one network device, and there are two terminal devices (a terminal device A and a terminal device B). When the network device is a transmitting end, the terminal device A or the terminal device B is a receiving end; and when the terminal device A or the terminal device B is a transmitting end, the network device is a receiving end.

The terminal device may also be referred to as a terminal, user equipment (user equipment, UE), a mobile station, a mobile terminal, or the like. The terminal device may be widely used in various scenarios such as device-to-device (device-to-device, D2D), vehicle-to-everything (vehicle to everything, V2X) communication, machine type communication (machine-type communication, MTC), an internet of things (internet of things, IoT), virtual reality, augmented reality, industrial control, self-driving, telemedicine, a smart grid, smart furniture, a smart office, a smart wearable device, smart transportation, and a smart city. The terminal device may be a mobile phone, a tablet computer, a computer with a wireless transceiver function, a wearable device, a vehicle, an uncrewed aerial vehicle, a helicopter, an airplane, a ship, a robot, a robotic arm, a smart home device, a vehicle-mounted terminal, an IoT terminal, a wearable device, or the like. A specific technology and a specific device form that are used for the terminal device are not limited in embodiments of this application.

The network device may also be referred to as an access network (access network, AN) device or a radio access network (radio access network, RAN) device, and may be a base station (base station), an evolved NodeB (evolved NodeB, eNodeB), a transmission and reception point (transmission and reception point, TRP), an integrated access and backhaul (integrated access and backhauling, IAB) node, a next generation NodeB (next generation NodeB, gNB) in a 5th generation (5th generation, 5G) mobile communication system, a base station in a 6th generation (6th generation, 6G) mobile communication system, a base station in another future mobile communication system, an access node in a Wi-Fi system, a home base station (for example, a home evolved NodeB, or a home NodeB, HNB), an access point (access point, AP) in a wireless fidelity (wireless fidelity, Wi-Fi) system, a wireless relay node, a wireless backhaul node, and the like, or may be a module or unit that completes some functions of the base station, for example, may be a central unit (central unit, CU), or may be a distributed unit (distributed unit, DU). The CU herein completes functions of a radio resource control protocol and a packet data convergence protocol (packet data convergence protocol, PDCP) of the base station, and may further complete a function of a service data adaptation protocol (service data adaptation protocol, SDAP). The DU completes functions of a radio link control layer and a medium access control (medium access control, MAC) layer of the base station, and may further complete some or all of functions of a physical layer. For specific descriptions of the foregoing protocol layers, refer to technical specifications related to the 3rd generation partnership project (3rd generation partnership project, 3GPP). The network device may alternatively be a non-terrestrial (non-terrestrial) base station, for example, a low earth orbit (low earth orbit, LEO)/very low earth orbit (very low earth orbit, VLEO) satellite or a high altitude platform station (highattitude platform station, HAPS), or may be a terminal that is responsible for a function of the network device in V2X, D2D, and machine-to-machine (machine to machine, M2M) communication.

In embodiments of this application, a function of the network device may alternatively be performed by a module (for example, a chip) in the network device, or may be performed by a control subsystem including the function of the network device. The control subsystem including the function of the network device may be a control center in the foregoing application scenarios such as smart grid, industrial control, intelligent transportation, and smart city. The function of the terminal device may alternatively be performed by a module (for example, a chip or a modem) in the terminal device, or may be performed by an apparatus including a function of the terminal device.

The communication system shown in FIG. 1 is still used as an example. To ensure reliability of communication between devices, encoding and decoding processing may be performed on information. Refer to an encoding and decoding procedure shown in FIG. 2. A source of the transmitting end sequentially performs source encoding, channel encoding, and modulation, and then outputs a modulation symbol. After receiving the modulation symbol, the receiving end sequentially performs demodulation, channel decoding, and source recovery to obtain a sink. The receiving end may obtain useful information based on the sink.

For ease of understanding by a person skilled in the art, the following explains and describes some terms in embodiments of this application.

(1) Upper triangular matrix: A square matrix in which all elements below a main diagonal are zeros is referred to as the upper triangular matrix. The upper triangular matrix has the following properties: A determinant is multiplication of diagonal elements, the upper triangular matrix is still an upper triangular matrix after being multiplied by a coefficient, results of addition, subtraction, and multiplication between upper triangular matrixes are still upper triangular matrixes, and the like.

(2) Polar code encoding: A polar code is also a linear block code, a polarization transformation matrix is $G_N$, the polarization transformation matrix may also be denoted as G, and the polarization transformation matrix may also be referred to as an encoding matrix or a generator matrix. An encoding process is

$$x_1^N = u_1^N G_N \qquad u_1^N = (u1, u2, \ldots, uN)$$

, where is a binary row vector, that is, a binary sequence, a length is $N$, and $N$ is a code length of the polar code; and $G_N$ is an $N$

$\times N$ matrix, and $G_N = F_2^{\otimes(\log_2(N))}$ $F_2^{\otimes(\log_2(N))}$ may be defined as a Kronecker (kronecker) product of $\log_2 N$

$$F_2 = \begin{bmatrix} 1 & 0 \\ 1 & 1 \end{bmatrix}$$

matrixes $F_2$, where .

In the polar code encoding process, some bits in

$u_1^N$

are used to carry information, and the bits carrying the information are referred to as information bits. The bits used to carry the information form an information bit set, and a set of bit position indexes of the bits is denoted as A. Some other bits are set to fixed values agreed on in advance by the receiving end and the transmitting end, and are referred to as a fixed bit set or a frozen bit set (frozen bits); and a set of bit position indexes of the bits is represented by a complement set A $^c$ of A. The polar code encoding process is equivalent to

$$x_1^N = u_A G_{N.}(A) \oplus u_{A^c} G_{N.}(A^C)$$

. Herein, $G_N(A)$ is a submatrix obtained by using rows corresponding to the bit position indexes in the set A in $G_N$, and $G_N(A^C)$ is a submatrix obtained by using rows corresponding to the bit position indexes in the set A $^c$ in $G_N$. $u_A$ is the information bit set in $u_1^N$ , and a quantity of information bits is K;

and $u_{AC}$ is the frozen bit set in $u_1^N$ , a quantity of frozen bits is (N-K), and the frozen bits are known bits. The frozen bits are usually set to 0. However, the frozen bits may be randomly set provided that the receiving end and the transmitting end agree in advance. Therefore, an encoding output of the polar code may be simplified as:

$$x_1^N = u_A G_N (A)$$

. Herein, $u_A$ is the information bit set in $u_1^N$ , $u_A$ is a row vector of a length $K$, that is, $|A| = K$, $|\cdot|$ represents a quantity of elements in the set, $K$ is a size of an information block, or $K$ is a quantity of information bits, or K is a size of the information bit set, $G_N$ (A) is the submatrix obtained by using the rows corresponding to the bit position indexes in the set A in the matrix $G_N$, and $G_N(A)$ is a $K \times N$ matrix.

A polar code construction process is a selection process of the set A. This determines performance of the polar code. The polar code construction process is generally as follows: determining, based on the code length N, that there are a total of N polar channels that respectively correspond to N rows of the polarization transformation matrix; calculating channel reliability of the polar channels; and using bit position indexes of first K polar channels with high channel reliability as elements of the set A, and using bit position indexes corresponding to the remaining (N-K) polar channels as elements of the bit position index set A $^c$ of the frozen bits. The set A determines a position of the information bit, and the set A $^c$ determines a position of the frozen bit.

FIG. 3 shows an 8×8 polarization transformation matrix. FIG. 3 shows an example of a specific encoding process. A left side may be understood as a to-be-encoded side, a bit position on the left side is represented by u, a right side may be understood as an encoding side (or a codeword side), and a bit position on the right side is represented by x. A process from left to right is a process in which a transmitting end encodes a to-be-encoded bit sequence. To-be-encoded information bits are represented by a sequence u (0, 0, 0, 0, 0, 0, 1, 1), and after being encoded by using the polarization transformation matrix, encoded bits are represented by a sequence x (0, 1, 0, 1, 0, 1, 0, 1). If x is mapped to a modulation symbol, the modulation symbol may be transmitted on a channel W. A bit position corresponding to high channel reliability is used to map an information bit, and a bit position corresponding to low channel reliability is used to map a frozen bit. As shown in FIG. 3, {u0, u1, u2, u4} are frozen bit positions, that is, positions of frozen bits; and {u3, u5, u6, u7} are information bit positions, that is, positions of information bits.

Refer to FIG. 3 for further description. In an encoding process, two adjacent columns are an encoding layer, bits on a left column are input bits of the encoding layer, and bits on a right column are output bits of the encoding layer. For example, in a leftmost encoding layer, a bit sequence (0, 0, 0, 0, 0, 0, 1, 1) is inputted, and a bit sequence (0, 0, 0, 0, 0, 0, 0, 1) is outputted. An operation symbol "⊕" in a middle of the encoding layer represents an exclusive OR operation, "⊕" represents one exclusive OR operation between a bit in a row in which "⊕" is located and a bit in a row reached by "⊕", and a bit on a right side of "⊕" is an operation result. For example, in the leftmost encoding layer, the "⊕" operation is performed on a 1st input bit (with a value of 0) and a 2nd input bit (with a value of 0), to obtain a 1st output bit (with a value of 0).

(3) Polar code decoding: A successive cancellation (successive cancellation, SC) decoding method is an effective polar code decoding algorithm. After obtaining a to-be-decoded symbol sequence, a decoding device calculates log likelihood ratios (log likelihood ratios, LLRs) of information bits one by one based on the to-be-decoded symbol sequence. If an LLR of an information bit is greater than 0, a decoding result is 0. If an LLR of an information bit is less than 0, a decoding result is 1. A decoding result of a frozen bit is set to 0 regardless of a value of an LLR.

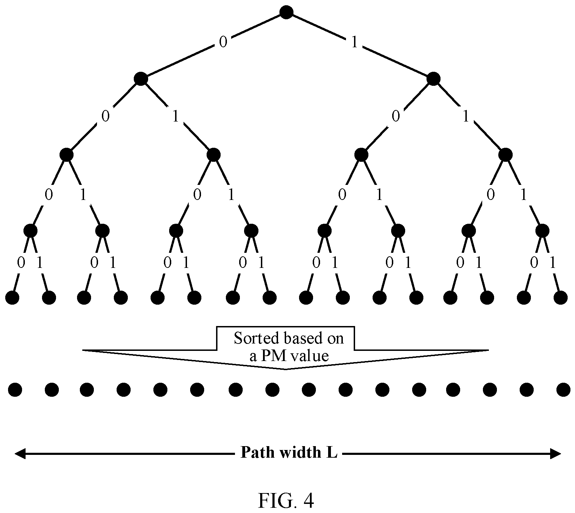

Performance of the SC decoding method is poor. A result of a former decoded bit is used as an input for calculating a latter decoded bit. Once there is a decision error, error extension is caused, and there is no opportunity for recovery. Consequently, decoding performance is not high. To resolve this problem, in a successive cancellation list (successive cancellation list, SCL) algorithm, when the SCL algorithm decodes each information bit, decoding results corresponding to 0 and 1 are both stored as two branch decoding paths (path splitting for short). FIG. 4 is a diagram of a decoding path in the SCL algorithm. As shown in FIG. 4, each level represents one decoded bit. If a decoding result is 0, a path is developed along a left subtree; or if a decoding result is 1, a path is developed along a right subtree. When a total quantity of decoding paths exceeds a preset path width L (usually, L is an integer power of 2), L paths having optimal path metric (path metric, PM) values are selected and stored, and a path continues to be developed to decode a subsequent decoded bit. A PM value is used to determine quality of a path, and the PM value is obtained through LLR calculation. For a decoded bit at each level, PM values of the L paths are sorted in ascending order, and a correct path is selected by using the PM values. This process is repeated until the last bit is decoded.

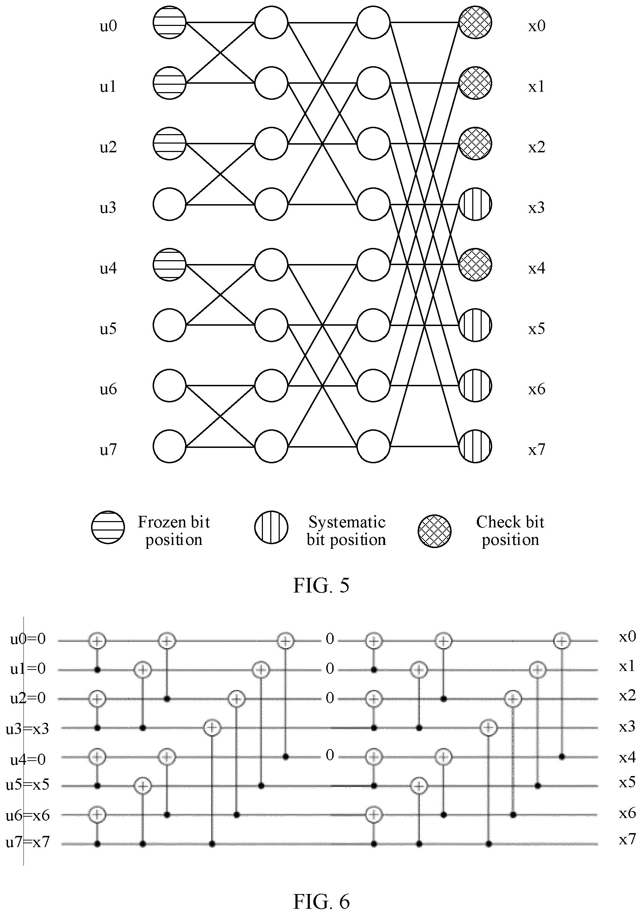

(4) Systematic polar code: The systematic polar code is a polar code whose information bits are directly carried on an encoding side (a codeword side). Compared with a non-systematic polar code, the systematic polar code has better BER performance, is more convenient to be concatenated with another code, is widely applied (for example, can be used for joint source-channel coding), and has other advantages. FIG. 5 is a diagram of an 8×8 systematic polar code. u0, u1, u2, and u4 on a to-be-encoded side are frozen bit positions, and may be used to carry frozen bits. x3, x5, x6, and x7 on an encoding side are systematic bit positions that actually carry information bits. A function of the systematic bit position is similar to a function of an information bit position of a non-systematic polar code. A systematic polar code encoding process may be understood as a process of determining, based on the frozen bits carried at the frozen bit positions and the information bits actually carried at the systematic bit positions, check bits carried at check bit positions (x0, x1, x2, and x4). A combination of the check bits and the information bits actually carried at the systematic bit positions is output as an encoded bit sequence.

Because a position relationship between the systematic bit position and the frozen bit position of the systematic polar code is mutual coupling, a current solution for encoding the systematic polar code is a serial encoding solution. In the serial encoding solution, $N\log_2 N$ encoding issues of the systematic polar code are continuously split into $N\log_2 N$ sub-encoding issues, and the $N\log_2 N$ sub-encoding issues are serially performed to complete an encoding process. Algorithm complexity is $N\log_2 N$. However, because the encoding process needs to be serially performed, a large encoding latency is caused. In addition, a common scenario to which the serial encoding solution is applied is an encoding process for a biased source (namely, an information bit sequence in which 0/1 is not evenly distributed). This needs to encode the biased source as an information bit, and then output an obtained check bit. However, it is very difficult to find an optimal code construction under an existing serial encoding framework. Specifically, all possible information bit placement manners need to be traversed, then respective error ratios are calculated, and then an optimal information bit placement manner is selected from the information bit placement manners. Therefore, complexity is high.

Another solution for encoding the systematic polar code is a parallel encoding method. As shown in FIG. 6, to carry information bits on x3, x5, x6, and x7 on an encoding side, in an encoding process, real information bits are first carried on corresponding u3, u5, u6, and u7 on a to-be-encoded side, and a non-systematic polar code encoding process is first performed. Further, bits corresponding to frozen bit positions of an obtained sequence are forcibly set to 0, the non-systematic polar code encoding process is performed on the sequence again, and then an obtained result is outputted, that is, the encoding process is completed. It can be learned that the method preserves high parallelism encoding of a non-systematic polar code. However, because the non-systematic polar code encoding process needs to be completed twice, computational complexity is $2N\log_2 N$, which is twice that of the non-systematic polar code encoding process.

It can be learned from the foregoing systematic polar code encoding solution that because the position relationship between the systematic bit position and the frozen bit position of the systematic polar (polar) code is mutual coupling, the encoding process needs to be serially performed or the non-systematic polar code encoding process needs to be performed in parallel for a plurality of times. Consequently, there are problems of high encoding complexity and limited encoding flexibility.

Based on this, this application provides an encoding method, a decoding method, and an apparatus. Through introduction of bit position mapping, bit position indexes of frozen bit positions and bit position indexes of systematic bit positions (bit positions actually carrying information bits) of a systematic polar code may overlap, and the systematic bit position and the frozen bit position of the systematic polar code are decoupled, to bring larger encoding design space, reduce encoding complexity, and improve encoding flexibility. The following describes in detail embodiments of this application with reference to the accompanying drawings.

In addition, it should be understood that ordinal numbers such as "first" and "second" mentioned in embodiments of this application are used to distinguish between a plurality of objects, and are not used to limit sizes, content, a sequence, a time sequence, priorities, importance degrees, or the like of the plurality of objects. For example, a first threshold and a second threshold may be a same threshold, or may be different thresholds. In addition, this type of name does not indicate that values, corresponding parameters, priorities, importance degrees, or the like of the two thresholds are different.

In embodiments of this application, unless otherwise specified, a quantity of nouns represents "a singular noun or plural nouns", that is, "one or more". "At least one" means one or more, and "a plurality of" means two or more. "And/or" describes an association relationship between associated objects and indicates that three relationships may exist. For example, A and/or B may indicate the following three cases: Only A exists, both A and B exist, and only B exists, where A and B may be singular or plural. The character "/" usually indicates an "or" relationship between the associated objects. For example, A/B indicates A or B. "At least one of the following items (pieces)" or a similar expression thereof refers to any combination of these items, including any combination of singular items (pieces) or plural items (pieces). For example, at least one item (piece) of a, b, or c may represent: a, b, c, a and b, a and c, b and c, or a, b, and c. Herein, a, b, and c may be singular or plural.

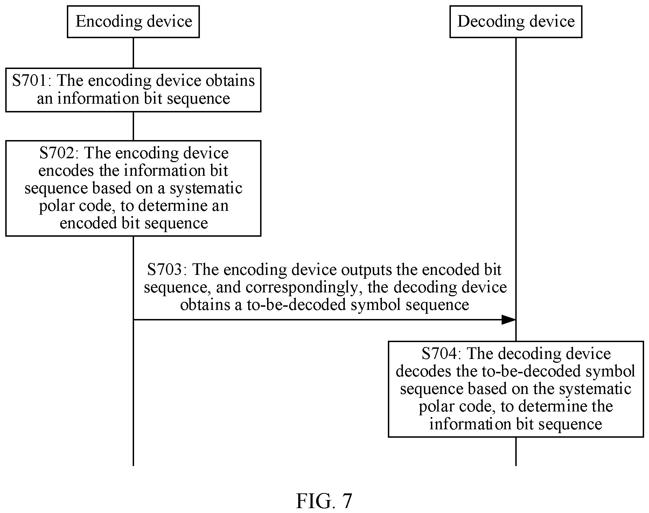

FIG. 7 is a diagram of an encoding and decoding method according to an embodiment of this application. In FIG. 7, an example in which an encoding device and a decoding device are used as execution bodies is used to illustrate the method. The encoding device may be a network device, and the decoding device may be a terminal device; or the encoding device is a terminal device, and the decoding device is a network device. The execution body of the method is not limited in this application. For example, the encoding device in FIG. 7 may be a chip, a chip system, a processor that can support the encoding device in implementing the method, or a logic module or software that can implement all or some functions of the encoding device. The decoding device in FIG. 7 may be a chip, a chip system, a processor that supports the decoding device in implementing the method, or a logic module or software that can implement all or some functions of the decoding device. The method includes the following steps.

S701: The encoding device obtains an information bit sequence.

S702: The encoding device encodes the information bit sequence based on a systematic polar code, to determine an encoded bit sequence.

The systematic polar code includes a polarization transformation matrix and N first bit positions and N second bit positions that correspond to the polarization transformation matrix, the N second bit positions include a systematic bit position set A and a non-systematic bit position set $M^A$, the N first bit positions include a frozen bit position set B and a non-frozen bit position set $M^B$, there is a frozen bit position subset C in B, there is a non-frozen bit position subset D in $M^B$, a frozen bit position in C and a non-frozen bit position in D are mapped to each other, C is determined based on a bit position index intersection set of B and A, D is determined based on a bit position index intersection set of $M^B$ and $M^A$, A is determined based on the information bit sequence, and the encoded bit sequence includes the information bit sequence.

Two sides of a polarization transformation matrix of a systematic polar code whose code length is N each correspond to N bit positions, which include N first bit positions on a left side (namely, a to-be-encoded side) of the polarization transformation matrix and N second bit positions on a right side (namely, an encoding side) of the polarization transformation matrix. The N first bit positions may correspond to the N second bit positions through the polarization transformation matrix, for example, bits carried at the N first bit positions and bits carried at the N second bit positions may be converted through the polarization transformation matrix.

In addition, for the systematic polar code whose code length is N, systematic bit positions may be used to carry the information bit sequence, and a total quantity of systematic bit positions and frozen bit positions is equal to the code length N of the systematic polar code. Therefore, in this embodiment of this application, A may be determined based on the information bit sequence. For example, if a length of the information bit sequence is K, A includes K systematic bit positions, B includes N-K frozen bit positions, $M^A$ includes N-K non-systematic bit positions, and $M^B$ includes K non-frozen bit positions. The length K of the information bit sequence may be agreed on in advance by the encoding device and the decoding device, may be indicated by the encoding device to the decoding device, or the like. For example, the encoding device and the decoding device agree on in advance that a bit rate is P, where P is less than or equal to 1. In this case, K=NP.

In addition, it should be understood that the non-frozen bit position in the systematic polar code may also be referred to as an information bit position. However, the information bit position (the non-frozen bit position) in the systematic polar code is not used to actually carry an information bit, but the systematic bit positions in the systematic polar code carry the information bit sequence. In other words, a function of the systematic bit position in the systematic polar code is equivalent to a function of an information bit position in a non-systematic polar code.

Different from a systematic polar code in which bit position indexes of systematic bit positions and bit position indexes of frozen bit positions in the systematic polar code are determined based on channel reliability of N polar channels corresponding to the code length N and are completely staggered, for example, a systematic polar code in which systematic bit positions and frozen bit positions are completely staggered shown in FIG. 5, in the systematic polar code provided in this embodiment of this application, bit position indexes of the systematic bit positions and bit position indexes of the frozen bit positions may not be completely staggered. In other words, an intersection set may exist between bit position indexes of the systematic bit position set A in the N second bit positions and bit position indexes of the frozen bit position set B in the N first bit positions.

For the systematic bit positions in A, in a possible implementation, last K second bit positions in the N second bit positions may be determined as the systematic bit positions, where K is equal to the length of the information bit sequence. In some implementations, if check encoding is performed on the information bit sequence, K may alternatively be equal to the length of the information bit sequence plus a length of check encoded bits (for example, CRC bits) obtained by performing check encoding such as cyclic redundancy check (cyclic redundancy check, CRC). An example in which N=8 and K=4 is used for description. Four second bit positions whose bit position indexes are 4, 5, 6, and 7 in the N second bit positions may be determined as the systematic bit positions.

In another possible implementation, K second bit positions in the N second bit positions may alternatively be determined as the systematic bit positions according to a bit inverse order (bit inverse order, BIV) rule, in a random selection manner, or the like. An example in which N=8 and K=4 is used for description. The eight second bit positions whose bit position indexes are 0 to 7 are expanded in binary as 000 001 010 011 100 101 110 111, and bit inverse (bit inverse) is performed on the binary, to obtain 000 100 010 110 001 101 011 111. Originally corresponding K bit position indexes, that is, 7, 3, 5, and 1, are selected in descending order, and four second bit positions whose bit position indexes are 7, 3, 5, and 1 in the N second bit positions are determined as the systematic bit positions.

For the frozen bit positions in B, in a possible implementation, N-K first bit positions may be selected from the N first bit positions based on channel reliability or codeword weights as the frozen bit positions. For example, N-K first bit positions with lowest channel reliability or lowest codeword weights are used as the frozen bit positions. The example in which N=8 and K=4 is still used for description. If a reliability sequence M of eight polar channels sorted based on channel reliability is [0, 1, 2, 4, 3, 5, 6, 7], four first bit positions whose bit position indexes are 0, 1, 2, and 4 in the N first bit positions may be determined as the frozen bit positions.

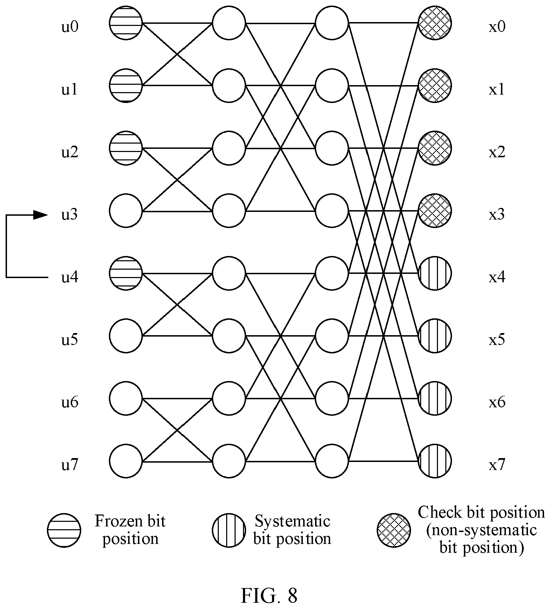

The example in which N=8 and K=4 is still used for description. As shown in FIG. 8, in this embodiment of this application, four (namely, K) second bit positions (x4, x5, x6, and x7) whose bit position indexes are 4, 5, 6, and 7 in eight (N=8) second bit positions may be determined as the systematic bit positions of the systematic polar code, four (namely, N-K) second bit positions (x0, x1, x2, and x3) whose bit position indexes are 0, 1, 2, and 3 may be determined as the non-systematic bits of the systematic polar code, and then it may be determined that the systematic bit position set A of the systematic polar code is {x4, x5, x6, x7}, and the non-systematic bit position set $M^A$ is {x0, x1, x2, x3}.

In addition, four (namely, N-K) first bit positions (u0, u1, u2, and u4) with lowest channel reliability of corresponding polar channels may be determined as the frozen bit positions of the systematic polar code, the remaining four (namely, K) first bit positions (u3, u5, u6, and u7) are determined as the non-frozen bit positions of the systematic polar code, and then it may be determined that the frozen bit position set B of the systematic polar code is {u0, u1, u2, u4}, and the non-frozen bit position set $M^B$ is {u3, u5, u6, u7}. The bit position index intersection set of B and A is 4, and it may be determined that the frozen bit position subset C is {u4}. The bit position index intersection set of $M^B$ and $M^A$ is 3, and it may be determined that the non-frozen bit position subset D is {u3}. A frozen bit position u4 in C and a non-frozen bit position u3 in D are mapped to each other.

In this embodiment of this application, that the frozen bit position in C and the non-frozen bit position in D are mapped to each other may be that a value of the frozen bit position in C one to one corresponds to and is the same as a value of the non-frozen bit position in D in sequence, or the value of the frozen bit position in C and the value of the non-frozen bit position in D may be mapped by using a mapping matrix Y, and may be represented as D=YC, where Y is a binary matrix (binary matrix). Y may be an $N_C$-dimensional (namely, $N_C*N_C$) full-rank matrix or identity matrix, where $N_C$ is equal to a quantity of frozen bit positions in C. In this case, the frozen bit position in C one to one corresponds to and is the same as the non-frozen bit position in D in sequence. In some implementations, Y may alternatively be an $N_C$-dimensional permutation matrix. In this case, the frozen bit position in C may not one to one correspond to and may not be the same as the non-frozen bit position in D in sequence.

In a possible implementation, that the information bit sequence is encoded based on the systematic polar code, to determine the encoded bit sequence may be implemented based on the following steps.

Step A1: Determine a first intermediate encoded bit sequence based on the information bit sequence and a first polarization transformation submatrix, where the first polarization transformation submatrix is a polarization transformation submatrix that corresponds to A and that is in the polarization transformation matrix, that is, the first polarization transformation submatrix is a submatrix of rows that correspond to bit position indexes of second bit positions in A and that are in the polarization transformation matrix.

Step A2: Determine a second intermediate encoded bit sequence based on the first intermediate encoded bit sequence, a mutual mapping relationship between the frozen bit position in C and the non-frozen bit position in D, and a bit position index intersection set of B and $M^A$, where a length of the second intermediate encoded bit sequence is equal to a quantity of second bit positions included in $M^A$.

Step A3: Determine the encoded bit sequence based on the second intermediate encoded bit sequence, a second polarization transformation submatrix, and the information bit sequence, where the second polarization transformation submatrix is a polarization transformation submatrix that corresponds to $M^A$ and that is in the polarization transformation matrix, that is, the second polarization transformation submatrix is a submatrix of rows that correspond to bit position indexes of second bit positions in $M^A$ and that are in the polarization transformation matrix.

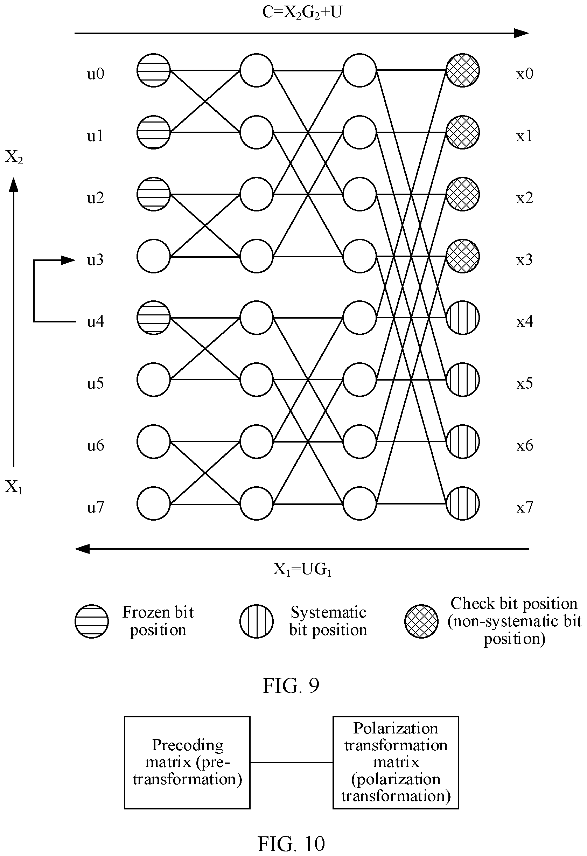

The systematic polar code shown in FIG. 8 is still used as an example. For encoding the information bit sequence based on the systematic polar code, to determine the encoded bit sequence, refer to an implementation shown in FIG. 9. Step A1: The encoding device multiplies an information bit sequence U (corresponding to bits carried in A, which may also be referred to as corresponding to values of A) by a first polarization transformation submatrix $G_1$ obtained by using rows that correspond to bit position indexes of second bit positions in A and that are in a polarization transformation matrix G, to obtain a first intermediate encoded bit sequence $X_1$, where $X_1$ corresponds to bits carried by u4 to u7.

Step A2: The encoding device may determine, based on a mutual mapping relationship between a frozen bit position u4 in C and a non-frozen bit position u3 in D, and a bit carried by corresponding u4 in $X_1$, a bit carried by u3, and may determine, based on a bit position index intersection set {0, 1, 2} of B {u0, u1, u2, u4} and $M^A$ {x0, x1, x2, x3}, frozen bits carried by u0, u1, and u2. For example, if values of the frozen bits are set to 0, a second intermediate encoded bit sequence $X_2$ may be obtained, where $X_2=[0, 0, 0, u3]$.

Step A3: The encoding device multiplies $X_2$ by a second polarization transformation submatrix $G_2$ obtained by using rows that correspond to bit position indexes of second bit positions in $M_A$ and that are in the polarization transformation matrix G, to obtain an intermediate check bit sequence $C_1$, performs an exclusive OR operation on the intermediate check bit sequence $C_1$

and the information bit sequence U, to obtain a check bit sequence C, where C corresponds to bits carried by x1 to x4, and splices C and U, to obtain the encoded bit sequence.

When the exclusive OR operation is performed on $C_1$ and U, the exclusive OR operation is sequentially performed on intermediate check bits in $C_1$ and information bits in U one by one. For example, the exclusive OR operation is performed on an intermediate check bit corresponding to x0 in $C_1$ and an information bit corresponding to x4 in U, the exclusive OR operation is performed on an intermediate check bit corresponding to x1 in $C_1$ and an information bit corresponding to x5 in U, the exclusive OR operation is performed on an intermediate check bit corresponding to x2 in $C_1$ and an information bit corresponding to x6 in U, and the exclusive OR operation is performed on an intermediate check bit corresponding to x3 in $C_1$ and an information bit corresponding to x7 in U.

It should be understood that, when the exclusive OR operation is performed on $C_1$ and U, a principle of performing the exclusive OR operation on a bit whose corresponding bit position index is 0 and a bit whose corresponding bit position index is N/2, performing the exclusive OR operation on a bit whose corresponding bit position index is 1 and a bit whose corresponding bit position index is N/2+1, ..., and performing the exclusive OR operation on a bit whose corresponding bit position index is N/2-1 and a bit whose corresponding bit position index is N-1 may be followed.

The foregoing is described by using an example in which bit positions included in A and bit positions include in $M^A$ are the same, that is, a length of the information bit sequence U is equal to a length of the intermediate check bit sequence $C_1$. It may be understood that, in some embodiments, bit positions included in A and bit positions included in $M^A$ may alternatively be different, that is, a length of U may not be equal to a length of $C_1$.

In an example, N=8, K=3, A is {x5, x6, x7}, and $M^A$ is {x0, x1, x2, x3, x4}. In this case, the intermediate check bit sequence $C_1$ includes five intermediate check bits, which respectively correspond to x0, x1, x2, x3, and x4, and the information bit sequence U includes three information bits, which respectively correspond to x5, x6, and x7. When the exclusive OR operation is performed on $C_1$ and U, the exclusive OR operation is performed on an intermediate check bit corresponding to x0 and an intermediate check bit corresponding to x4 in $C_1$, to obtain a check bit corresponding to x0 in the check bit sequence C; the exclusive OR operation is performed on an intermediate check bit corresponding to x1 in $C_1$ and an information bit corresponding to x5 in U, to obtain a check bit corresponding to x1 in the check bit sequence C; the exclusive OR operation is performed on an intermediate check bit corresponding to x2 in $C_1$ and an information bit corresponding to x6 in U, to obtain a check bit corresponding to x2 in the check bit sequence C; the exclusive OR operation is performed on an intermediate check bit corresponding to x3 in $C_1$ and an information bit corresponding to x7 in U, to obtain a check bit corresponding to x3 in the check bit sequence C; and the exclusive OR operation is performed on an intermediate check bit corresponding to x4 and the intermediate check bit corresponding to x0 in $C_1$, to obtain a check bit corresponding to x4 in the check bit sequence C.

In another example, N=16 and K=9 are used for description. A reliability sequence M of 16 polar channels sorted based on channel reliability is [0, 1, 2, 4, 8, 3, 5, 9, 6, 10, 12, 7, 11, 13, 14, 15]. In this case, the systematic bit position set A is {x7, x8, x9, x10, x11, x12, x13, x14, x15}, the non-systematic bit position set $M^A$ is {x0, x1, x2, x3, x4, x5, x6}, the frozen bit position set B is {u0, u1, u2, u4, u8, u3, u5}, and the non-frozen bit position set $M^B$ is {u9, u6, u10, u12, u7, u11, u13, u14, u15}, where a bit position index intersection set of A and B is {8}, and a bit position index intersection set of $M^B$ and $M^A$ is {6}. It may be determined that the frozen bit position subset C is {u8} and the non-frozen bit position subset D is {u6}. A frozen bit position u8 in C and a non-frozen bit position u6 in D are mapped to each other. For the systematic polar code in which N=16 and K=9, the determined intermediate check bit sequence $C_1$ includes seven intermediate check bits, which respectively correspond to x0, x1, x2, x3, x4, x5, and x6, and the information bit sequence U includes nine information bits, which respectively correspond to x7, x8, x9, x10, x11, x12, x13, x14, and x15. When the exclusive OR operation is performed on $C_1$ and U, the exclusive OR operation is performed on an intermediate check bit corresponding to x0 in $C_1$ and an information bit corresponding to x8 in U, to obtain a check bit corresponding to x0 in the check bit sequence C; the exclusive OR operation is performed on an intermediate check bit corresponding to x1 in $C_1$ and an information bit corresponding to x9 in U, to obtain a check bit corresponding to x1 in the check bit sequence C; the exclusive OR operation is performed on an intermediate check bit corresponding to x2 in $C_1$ and an information bit corresponding to x10 in U, to obtain a check bit corresponding to x2 in the check bit sequence C; the exclusive OR operation is performed on an intermediate check bit corresponding to x3 in $C_1$ and an information bit corresponding to x11 in U, to obtain a check bit corresponding to x3 in the check bit sequence C; the exclusive OR operation is performed on an intermediate check bit corresponding to x4 in $C_1$ and an information bit corresponding to x12 in U, to obtain a check bit corresponding to x4 in the check bit sequence C; the exclusive OR operation is performed on an intermediate check bit corresponding to x5 in $C_1$ and an information bit corresponding to x13 in U, to obtain a check bit corresponding to x5 in the check bit sequence C; and the exclusive OR operation is performed on an intermediate check bit corresponding to x6 in $C_1$ and an information bit corresponding to x14 in U, to obtain a check bit corresponding to x6 in the check bit sequence C.

Complexity of encoding the information bit sequence based on the systematic polar code, to determine the encoded bit sequence does not exceed $K(\log_2 N-1)$ $+(N-K)(\log_2 N-1)+N$, where $K(\log_2 N-1)$ corresponds to encoding complexity of step A1, and encoding complexity corresponding to step A3 does not exceed $(N-K)$ $(\log_2 N-1)+N$, encoding complexity of performing the exclusive OR operation on $C_1$ and U in step A3 does not exceed N, and step A2 is bit position mapping and does not involve encoding complexity.

The example in which N=8 and K=4 is still used. Encoding complexity in FIG. 9 is $4\log_2(4)+4^*\log_2(4)$ $+8=8^*\log_2(8)$. Complexity of the non-systematic code encoding process performed twice shown in FIG. 6 is $2^*8^*\log_2(8)$. The encoding complexity in this embodiment of this application is 1/2 of that of the non-systematic code encoding process performed twice.

It should be understood that, an encoding manner used for encoding the systematic polar code is not limited in this embodiment of this application, and encoding may alternatively be implemented by using an encoding manner such as serial encoding.

The systematic polar code is not optimized for a code spectrum. Consequently, performance of a short code (a code length N is small) is poor. To resolve this problem, in this embodiment of this application, a check code, a convolutional code (convolutional code), or the like may be further concatenated before the systematic polar code to improve performance of the systematic polar code. Different encoding forms such as a convolutional code may be unified as pre-transformation (pre-transformation) corresponding to a precoding matrix, and different encoding forms correspond to different precoding matrixes. FIG. 10 is a diagram of pre-transforming a systematic polar code. A precoding matrix and a polarization transformation matrix of the systematic polar code may be concatenated, and encoding is performed through pre-transformation corresponding to the precoding matrix and polarization transformation (polarization transformation) corresponding to the polarization transformation matrix, so as to reduce a BER and improve performance of the systematic polar code.

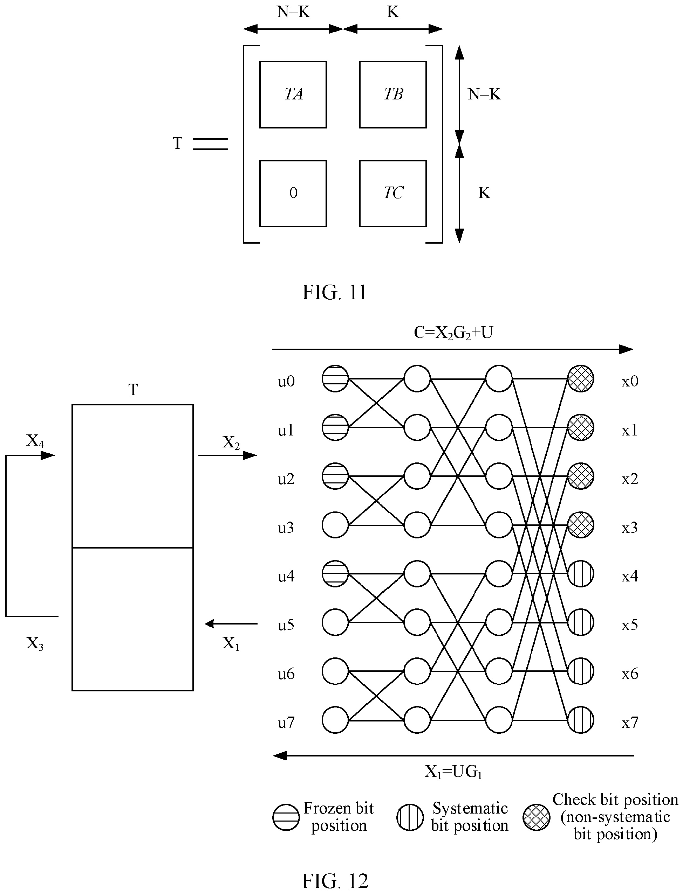

In this embodiment of this application, the precoding matrix may be an N-dimensional upper triangular matrix, that is, the upper triangular matrix has N rows and N columns, where N is a code length of the systematic polar code. Specifically, as shown in FIG. 11, the N-dimensional upper triangular matrix T may be represented as $\begin{bmatrix} TA & TB \\ 0 & TC \end{bmatrix}$, where a quantity of rows of TA and a quantity of rows of TB are determined based on a quantity of nonsystematic bit positions in $M^A$, a quantity of rows of TC is determined based on a quantity of systematic bit positions in A, a quantity of columns of TA is determined based on the quantity of non-systematic bit positions in $M^A$, and a quantity of columns of TB and a quantity of columns of TC are determined based on the quantity of systematic bit positions in A. In other words, the quantity of rows of *TA* and the quantity of rows of *TB* are N-K, the quantity of rows of 0 and the quantity of rows of *TC* are K, the quantities of columns of 0 and *TA* are K, the quantity of columns of *TA* and the quantity of columns of *TB* are N-K, and 0 represents a matrix whose elements are all zeros.

In a possible implementation, when the precoding matrix is the upper triangular matrix, that the information bit sequence is encoded based on the systematic polar code, to determine the encoded bit sequence may be implemented based on the following steps.

Step B1: Determine a first intermediate encoded bit sequence based on the information bit sequence and a first polarization transformation submatrix, where the first polarization transformation submatrix is a polarization transformation submatrix that corresponds to A and that is in the polarization transformation matrix, that is, the first polarization transformation submatrix is a submatrix of rows that correspond to bit position indexes of second bit positions in A and that are in the polarization transformation matrix.

Step B2: Determine a third intermediate encoded bit sequence based on the first intermediate encoded bit sequence, *TC,* and *TB.*

Step B3: Determine a fourth intermediate encoded bit sequence based on the third intermediate encoded bit sequence, a mutual mapping relationship between the frozen bit position in C and the non-frozen bit position in D, and the bit position index intersection set of B and $M^A$.

Step B4: Determine a second intermediate encoded bit sequence based on the fourth intermediate encoded bit sequence, and *TA.*

Step B5: Determine the encoded bit sequence based on the second intermediate encoded bit sequence, a second polarization transformation submatrix, and the information bit sequence, where the second polarization transformation submatrix is a polarization transformation submatrix that corresponds to $M^A$ and that is in the polarization transformation matrix, that is, the second polarization transformation submatrix is a submatrix of rows that correspond to bit position indexes of second bit positions in $M^A$ and that are in the polarization transformation matrix.

For implementations of B1 and B5, refer to the implementations of A1 and A3. Details are not described herein again.

An example in which a systematic polar code is concatenated with a precoding matrix T (T shown in FIG. 11) shown in FIG. 12 is used. $X_1$ represents a first intermediate encoded sequence, $X_2$ represents a second intermediate encoded sequence, $X_3$ represents a third intermediate encoded sequence, and $X_4$ represents a fourth intermediate encoded sequence. $X_1$ and $X_2$ may be converted into $X_3$ and $X_4$ by pre-transforming the matrix T.

Step B2: Because $[X_3X_4]T=[X_1X_2]$, that is, $[X_4TB+X_3TC]=X_1$, because u4 and u3 are mapped to

each other, $X_4$ may be determined based on $X_3$. For example, a value of u4 one to one corresponds to and is the same as a value of u3, and a value corresponding to u3 in $X_4$ may be equal to a value corresponding to u4 in $X_3$, that is, a value whose bit position index is 3 in $X_4$ may be equal to a value whose bit position index is 4 in $X_3$. Therefore, $[X_4\ TB+X_3\ TC]=X_1$ may be converted into

$$X_3[TC+\widetilde{TB}]=X_1,$$

where *TB* is formed based on rows corresponding to bit position indexes in the set D in *TB* and a matrix 0, that is, a matrix constructed based on rows corresponding to (u3) in *TB* and the matrix 0. Therefore, the third intermediate encoded bit sequence $X_3$ may be determined based on the first intermediate encoded bit sequence $X_1$, *TC,* and *TB.*

Step B3: The value whose corresponding bit position index is 3 in $X_4$ may be determined based on a mutual mapping relationship between the frozen bit position u4 in C and the non-frozen bit position u3 in D. For example, the mutual mapping relationship is that the value of u4 one to one corresponds to and is the same as the value of u3, and the value whose corresponding bit position index is 3 in $X_4$ may be the same as the value whose corresponding bit position index is 4 in $X_3$. With reference to a bit position index intersection set {0, 1, 2} of B (u0, u1, u2, u4) and $M^A$ (x0, x1, x2, x3), $X_4$ may be obtained, where $X_4=[0, 0, 0, X_3(4)]$. $X_3(4)$ is the value whose corresponding bit position index is 3 in $X_4$ and that is determined based on the value whose bit position index is 4 in $X_3$ and the mutual mapping relationship. For example, when the mutual mapping relationship is that the value of u4 one to one corresponds to and is the same as the value of u3, $X_3(4)$ is the value whose corresponding bit position index is 4 in $X_3$.

Step B4: Multiply $X_4$ by A to obtain $X_2$.

S703: The encoding device outputs the encoded bit sequence, and correspondingly, the decoding device obtains a to-be-decoded symbol sequence.

The encoded bit sequence is modulated by a transmitting end, to obtain a modulation symbol, and the modulation symbol is received by the decoding device through channel transmission. The decoding device demodulates the received modulation symbol to obtain the to-be-decoded symbol sequence. The to-be-decoded symbol sequence corresponds to the encoded bit sequence, and is generally obtained by transforming the encoded bit sequence due to interference factors such as noise in a channel. In other words, the to-be-decoded symbol sequence may be understood as an encoded bit sequence that is interfered by the channel or the like.

S704: The decoding device decodes the to-be-decoded symbol sequence based on the systematic polar code, to determine the information bit sequence.

For implementations of how the decoding device determines A, $M^A$, B, $M^B$, C, and D, refer to the implementations on the encoding device side. Details are not described again.

In this embodiment of this application, decoding may be performed by using a decoding method such as SC decoding or SCL decoding.

In an example, the decoding device may first determine a first intermediate decoded bit sequence based on the to-be-decoded symbol sequence, the polarization transformation matrix, the mutual mapping relationship between the frozen bit position in C and the non-frozen bit position in D, and the bit position index intersection set of B and $M^A$. Then, the decoding device determines the information bit sequence based on the first intermediate decoded bit sequence and the polarization transformation matrix.

It should be understood that, during decoding, a value of the non-frozen bit position in D may be first decoded, and a value of the frozen bit position in C is determined based on the value of the non-frozen bit position in D. For example, in a decoding process, u3 is first decoded, and when u4 is decoded, because u3 and u4 are mapped to each other, u4 may be determined based on u3, and u4 may be directly used as the frozen bit. The following uses an example in which that u3 and u4 are mapped to each other is that a value of u3 is equal to a value of u4 for description.

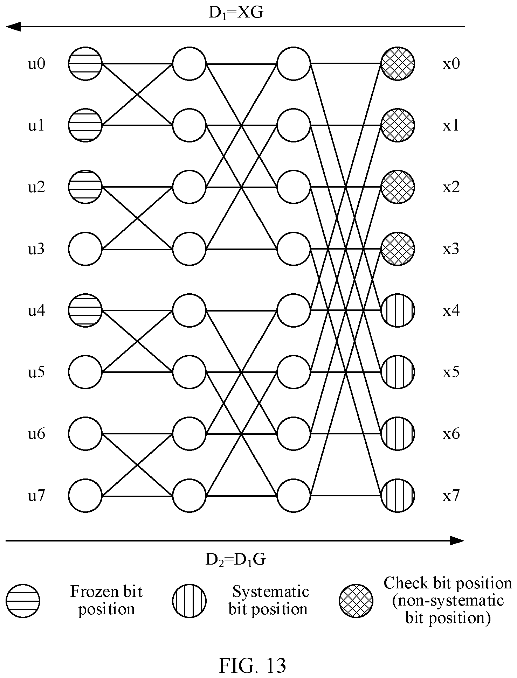

In an example, as shown in FIG. 13, the decoding device may first determine values of a first intermediate decoded bit sequence $D_1$, that is, u0 to u7, by using an SCL decoding method based on values of a to-be-decoded symbol sequence X, that is, x0 to x7, and a polarization transformation matrix G, where in a decoding process, a constraint condition in which u0 to u2 are pre-agreed values of frozen bits and a value of u4 is equal to a value of u3 needs to be maintained; and determine a second intermediate decoded sequence $D_2$ based on a product of determined $D_1$ and G, where values corresponding to A (x4 to x7) in $D_2$ is the information bit sequence.

In some implementations, check encoding such as cyclic redundancy check (cyclic redundancy check, CRC) encoding may be further added to the systematic polar code, and a check encoded bit position such as a CRC bit position is set, to improve decoding reliability. The CRC encoding is used as an example. The decoding device may perform decoding by using a CRC-assisted SCL decoding method. To be specific, the decoding device first performs decoding based on the SCL decoding method, to obtain L decoding paths, when the decoding ends, respectively determines, for the L decoding paths based on a value of the CRC bit position, a value of a bit position on which CRC encoding is performed, selects, based on a determining result, a path that passing through CRC determining from the L decoding paths, and outputs the path as a final decoding result.

It should be understood that, if check encoding is performed on the information bit sequence, K may alternatively be equal to a length of the information bit sequence plus a length of check encoded bits (for example, CRC bits) obtained through check encoding. In other words, A includes a position of an information bit and a position of a check encoded bit (for example, a CRC bit) corresponding to the information bit. For example, A includes bit position indexes of bit positions, and K is equal to a sum of bit position indexes of systematic bit positions that actually carry the information bit sequence and bit position indexes of check encoded bit positions (for example, CRC bit positions). An example in which the check encoding is CRC check encoding, the check encoded bit is a CRC bit, and the check encoded bit position is a CRC bit position is used below for description.

In a possible implementation, the CRC bit position may be on an encoding side. A CRC bit carried at the CRC bit position is obtained by performing check encoding on the information bit sequence, and the obtained CRC bit and the information bit sequence are encoded together by using a systematic polar code.

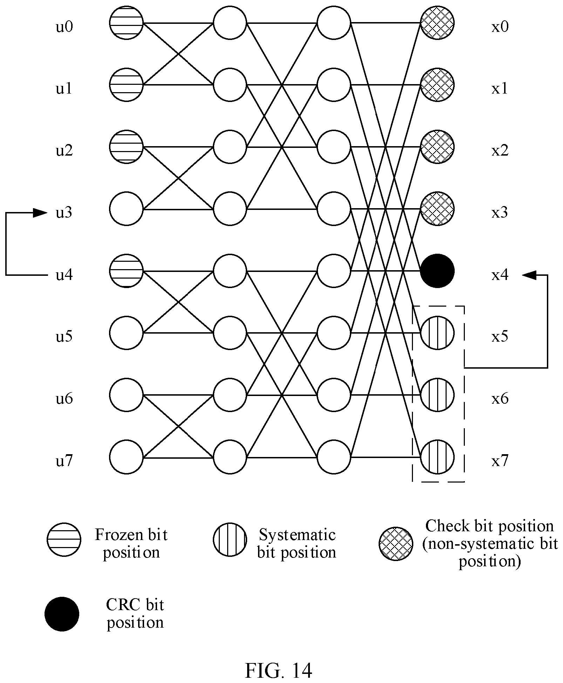

In an example, as shown in FIG. 14, CRC check encoding may be performed on an information bit sequence carried at systematic bit positions (x5, x6, and x7) that actually carry the information bit sequence, a CRC bit carried at a CRC bit position (x4), that is, a value of the CRC bit position, is determined, and the information bit sequence is concatenated with the CRC bit as a new information bit sequence for encoding.

During decoding, verification on values of x5, x6, and x7 (namely, the actually carried information bit sequence) by using the value (namely, the carried CRC bit) of CRC bit position x4 needs to succeed.

In this implementation, check encoding is easy to implement, and the CRC bit position is set, so that an error correction capability of decoding can be improved, and decoding reliability can be improved.

In another possible implementation, the CRC bit position may be on a to-be-encoded side, and a CRC bit carried at the CRC bit position may be determined based on a non-CRC bit part in the first intermediate encoded bit sequence. For example, the first intermediate encoded bit sequence may include a fifth intermediate encoded bit sequence and the CRC bit, the fifth intermediate encoded bit sequence is determined based on the information bit sequence and the first polarization transformation submatrix, and the CRC bit is determined based on the fifth intermediate encoded bit sequence.

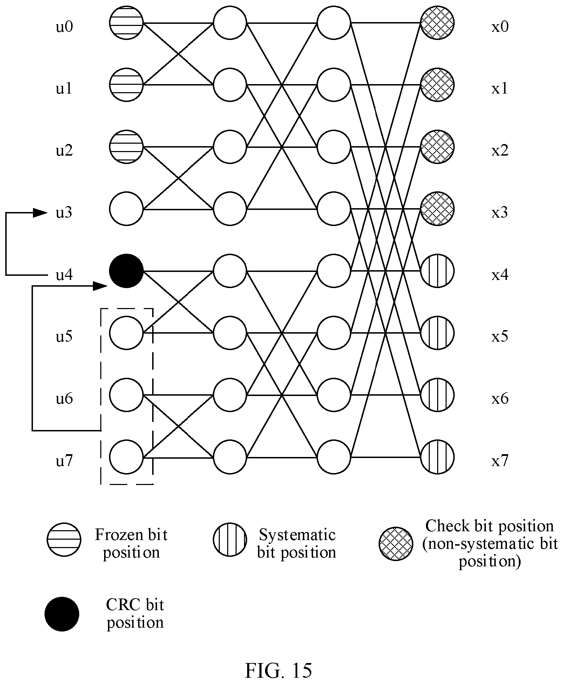

In an example, as shown in FIG. 15, products of an information bit sequence carried at systematic bit positions (x5, x6, and x7) that actually carry the information bit sequence and a first polarization transformation submatrix (for example, rows whose corresponding bit position indexes are 5, 6, and 7 in the first polarization transformation submatrix) may be determined as a fifth intermediate encoded bit sequence (values corresponding to u5, u6, and u7), CRC check encoding is performed on the fifth intermediate encoded bit sequence, a CRC bit carried at a CRC bit position (u4), that is, a value of the CRC bit position, is determined, and the fifth intermediate encoded bit sequence is concatenated with the CRC bit as a first intermediate encoded sequence for continuous encoding. A value of a second bit position (namely, a bit position on an encoding side) corresponding to the CRC bit position, for example, a value of x4 in FIG. 15, may be determined by using a product of the CRC bit and a row that corresponds to a bit position index of the CRC bit position and that is in the first polarization encoding submatrix.

During decoding, the first intermediate decoded bit sequence includes a second intermediate decoded bit sequence (values corresponding to u5, u6, and u7) and the CRC bit (a value corresponding to u4), the CRC bit is used to check the second intermediate decoded bit sequence, the second intermediate decoded bit sequence corresponds to the positions (the bit position indexes 5, 6, and 7) of the information bits, and the CRC bit corresponds to the position (the bit position index 4) of the CRC bit.

In this implementation, the CRC bit position is set on a to-be-encoded side (namely, a non-codeword side) of the systematic polar code, and a check relationship is formed between the CRC bit and the encoded bit sequence on the to-be-encoded side, thereby facilitating early stop of decoding.

In another possible implementation, the CRC bit position may alternatively be on an encoding side, and a CRC bit carried at the CRC bit position is obtained by performing check encoding on the information bit sequence. In other words, the first intermediate encoded bit sequence may include a fifth intermediate encoded bit sequence and the CRC bit, the fifth intermediate encoded bit sequence is determined based on the information bit sequence and the first polarization transformation submatrix, and the CRC bit is determined based on the information bit sequence.

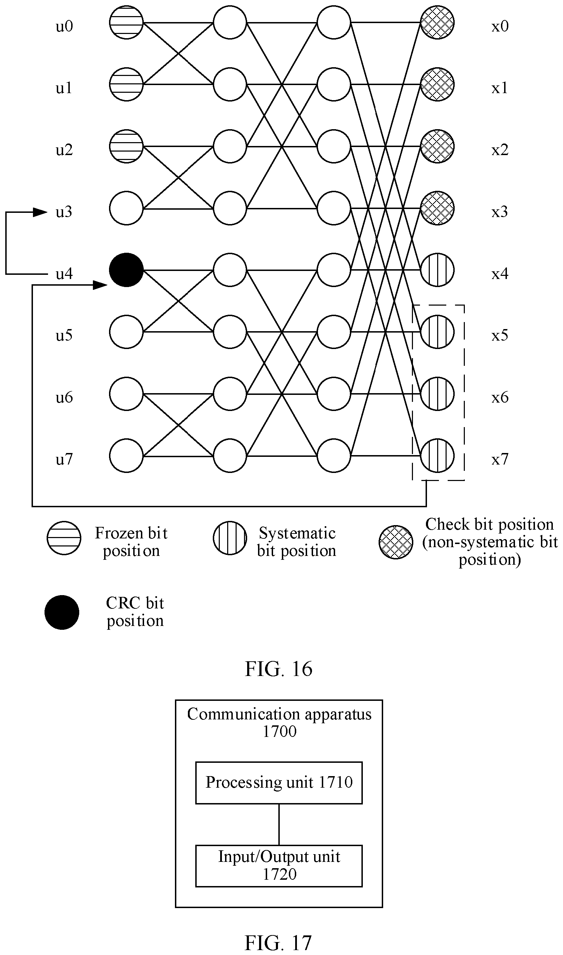

In an example, as shown in FIG. 16, products of an information bit sequence carried at systematic bit positions (x5, x6, and x7) that actually carry the information bit sequence and a first polarization transformation submatrix (for example, rows whose corresponding bit position indexes are 5, 6, and 7 in the first polarization transformation submatrix) may be determined as a fifth intermediate encoded bit sequence (values corresponding to u5, u6, and u7), CRC check encoding is performed on the information bit sequence, a CRC bit carried at a CRC bit position (u4), that is, a value of the CRC bit position, is determined, and the fifth intermediate encoded bit sequence is concatenated with the CRC bit as a first intermediate encoded sequence for continuous encoding. A value of a second bit position (namely, a bit position on an encoding side) corresponding to the CRC bit position, for example, a value of x4 in FIG. 16, may be determined by using a product of the CRC bit and a row that corresponds to a bit position index of the CRC bit position and that is in the first polarization encoding submatrix.

During decoding, a CRC bit (a value corresponding to u4) in the first intermediate decoded bit sequence is used to check an information bit sequence (namely, values of x5, x6, and x7).

In this implementation, performance can be balanced in the foregoing two check bit settings, and performance can be balanced between simple implementation of check encoding and early stop of decoding.

It may be understood that, to implement the functions in the foregoing embodiments, the encoding device and the decoding device include corresponding hardware structures and/or software modules for performing the functions. A person skilled in the art should be easily aware that, in combination with the units and the method steps in the examples described in embodiments disclosed in this application, this application can be implemented by using hardware or a combination of hardware and computer software. Whether a function is performed by hardware or hardware driven by computer software depends on particular application scenarios and design constraint conditions of the technical solutions.

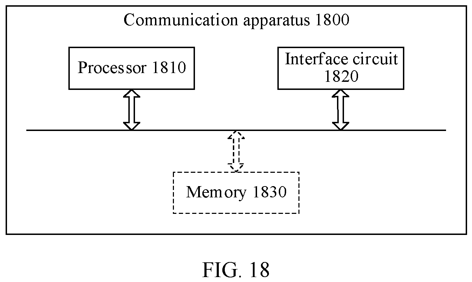

FIG. 17 and FIG. 18 each are a diagram of a structure of a possible communication apparatus according to an embodiment of this application. These communication apparatuses may be configured to implement the functions of the encoding device or the decoding device in the foregoing method embodiments. Therefore, beneficial effects of the foregoing method embodiments can also be implemented.

As shown in FIG. 17, the communication apparatus 1700 includes a processing unit 1710 and an input/output unit 1720. The input/output unit 1720 may be further a transceiver unit, an interface unit, or an input/output interface. The communication apparatus 1700 may be configured to implement the functions of the encoding device or the decoding device in the method embodiment shown in FIG. 7.

When the communication apparatus 1700 is configured to implement the functions of the encoding device in the method embodiment shown in FIG. 7, the input/output unit 1720 is configured to obtain an information bit sequence; the processing unit 1710 is configured to encode the information bit sequence based on a systematic polar code, to determine an encoded bit sequence, where the systematic polar code includes a polarization transformation matrix and N first bit positions and N second bit positions that correspond to the polarization transformation matrix, the N second bit positions include a systematic bit position set A and a non-systematic bit position set $M^A$, the N first bit positions include a frozen bit position set B and a non-frozen bit position set $M^B$, there is a frozen bit position subset C in B, there is a non-frozen bit position subset D in $M^B$, a frozen bit position in C and a non-frozen bit position in D are mapped to each other, C is determined based on a bit position index intersection set of B and A, D is determined based on a bit position index intersection set of $M^B$ and $M^A$, A is determined based on the information bit sequence, and the encoded bit sequence includes the information bit sequence; and the input/output unit 1720 is further configured to output the encoded bit sequence.

In a possible design, when encoding the information bit sequence based on the systematic polar code to determine the encoded bit sequence, the processing unit 1710 is specifically configured to determine a first intermediate encoded bit sequence based on the information bit sequence and a first polarization transformation submatrix, where the first polarization transformation submatrix is a polarization transformation submatrix that corresponds to A and that is in the polarization transformation matrix; determine a second intermediate encoded bit sequence based on the first intermediate encoded bit sequence, a mutual mapping relationship between the frozen bit position in C and the non-frozen bit position in D, and a bit position index intersection set of B and $M^A$, where a length of the second intermediate encoded bit sequence is equal to a quantity of second bit positions included in $M^A$; and determine the encoded bit sequence based on the second intermediate encoded bit sequence, a second polarization transformation submatrix, and the information bit sequence, where the second polarization transformation submatrix is a polarization transformation submatrix that corresponds to $M^A$ and that is in the polarization transformation matrix.

In a possible design, A includes last K second bit positions in the N second bit positions; and/or B includes N-K first bit positions selected from the N first bit positions based on channel reliability or codeword weights, where K is greater than or equal to 1 and less than N.

In a possible design, the systematic polar code is concatenated with a precoding matrix, and the precoding matrix is an upper triangular matrix $\begin{bmatrix} TA & TB \\ 0 & TC \end{bmatrix}$, where a quantity of rows of *TA* and a quantity of rows of *TB* are determined based on a quantity of non-systematic bit positions in $M^A$, a quantity of rows of *TC* is determined based on a quantity of systematic bit positions in A, a quantity of columns of *TA* is determined based on the quantity of non-systematic bit positions in $M^A$, and a quantity of columns of *TB* and a quantity of columns of *TC* are determined based on the quantity of systematic bit positions in A.

When encoding the information bit sequence based on the systematic polar code to determine the encoded bit sequence, the processing unit 1710 is specifically configured to determine the first intermediate encoded bit sequence based on the information bit sequence and the first polarization transformation submatrix, where the first polarization transformation submatrix is the polarization transformation submatrix that corresponds to A and that is in the polarization transformation matrix; determine a third intermediate encoded bit sequence based on the first intermediate encoded bit sequence, *TC,* and *TB;* determine a fourth intermediate encoded bit sequence based on the third intermediate encoded bit sequence, the mutual mapping relationship between the frozen bit position in C and the non-frozen bit position in D, and the bit position index intersection set of B and $M^A$; determine the second intermediate encoded bit sequence based on the fourth intermediate encoded bit sequence and *TA*; and determine the encoded bit sequence based on the second intermediate encoded bit sequence, the second polarization transformation submatrix, and the information bit sequence, where the second polarization transformation submatrix is the polarization transformation submatrix that corresponds to $M^A$ and that is in the polarization transformation matrix.

In a possible design, that A is determined based on the information bit sequence includes: A includes a position of an information bit and a position of a CRC bit corresponding to the information bit.

In a possible design, the first intermediate encoded bit sequence includes a fifth intermediate encoded bit sequence and the CRC bit, the fifth intermediate encoded bit sequence is determined based on the information bit sequence and the first polarization transformation submatrix, and the CRC bit is determined based on the fifth intermediate encoded bit sequence.

In a possible design, the first intermediate encoded bit sequence includes a fifth intermediate encoded bit sequence and the CRC bit, the fifth intermediate encoded bit sequence is determined based on the information bit sequence and the first polarization transformation submatrix, and the CRC bit is determined based on the information bit sequence.

In a possible design, that the frozen bit position in C and the non-frozen bit position in D are mapped to each other includes: the frozen bit position in C and the non-frozen bit position in D are mapped to each other based on a mapping matrix, where the mapping matrix is an $N_C$-dimensional full-rank matrix or an $N_C$-dimensional identity matrix, and $N_C$ is equal to a quantity of frozen bit positions in C.

When the communication apparatus 1700 is configured to implement the functions of the decoding device in the method embodiment shown in FIG. 7, the input/output unit 1720 is configured to obtain a to-be-decoded symbol sequence; and the processing unit 1710 is configured to decode the to-be-decoded symbol sequence based on a systematic polar code, to determine an information bit sequence, where the systematic polar code includes a polarization transformation matrix and N first bit positions and N second bit positions that correspond to the polarization transformation matrix, the N second bit positions include a systematic bit position set A and a non-systematic bit position set $M^A$, the N first bit positions include a frozen bit position set B and a non-frozen bit position set $M^B$, there is a frozen bit position subset C in B, there is a non-frozen bit position subset D in $M^B$, a frozen bit position in C and a non-frozen bit position in D are mapped to each other, C is determined based on a bit position index intersection set of B and A, D is determined based on a bit position index intersection set of $M^B$ and $M^A$, and A is determined based on the information bit sequence.

In a possible design, when decoding the to-be-decoded symbol sequence based on the systematic polar code to determine the information bit sequence, the processing unit 1710 is specifically configured to determine a first intermediate decoded bit sequence based on the to-be-decoded symbol sequence, the polarization transformation matrix, a mutual mapping relationship between the frozen bit position in C and the non-frozen bit position in D, and a bit position index intersection set of B and $M^A$; and determine the information bit sequence based on the first intermediate decoded bit sequence and the polarization transformation matrix.

In a possible design, A includes last K second bit positions in the N second bit positions; and/or B includes N-K first bit positions selected from the N first bit positions based on channel reliability or codeword weights, where K is greater than or equal to 1 and less than N.

In a possible design, that A is determined based on the information bit sequence includes: A includes a position of an information bit and a position of a CRC bit corresponding to the information bit.

In a possible design, the first intermediate decoded bit sequence includes a second intermediate decoded bit sequence and the CRC bit, the CRC bit is used to check the second intermediate decoded bit sequence, the second intermediate decoded bit sequence corresponds to the position of the information bit, and the CRC bit corresponds to the position of the CRC bit.

In a possible design, the first intermediate decoded bit sequence includes a second intermediate decoded bit sequence and the CRC bit, the CRC bit is used to check the information bit sequence, the second intermediate decoded bit sequence corresponds to the position of the information bit, and the CRC bit corresponds to the position of the CRC bit.

In a possible design, that the frozen bit position in C and the non-frozen bit position in D are mapped to each other includes: the frozen bit position in C and the non-frozen bit position in D are mapped to each other based on a mapping matrix, where the mapping matrix is an $N_C$-dimensional full-rank matrix or an $N_C$-dimensional identity matrix, and $N_C$ is equal to a quantity of frozen bit positions in C.

As shown in FIG. 18, the communication apparatus 1800 includes a processor 1810 and an interface circuit 1820. The processor 1810 and the interface circuit 1820 are coupled to each other. It may be understood that the interface circuit 1820 may be a transceiver or an input/output interface. Optionally, the communication apparatus 1800 may further include a memory 1830, configured to store instructions executed by the processor 1810, or input data needed by the processor 1810 to run the instructions, or data generated after the processor 1810 runs the instructions. Optionally, the memory 1830 may be further integrated with the processor 1810.

When the communication apparatus 1800 is configured to implement the method shown in FIG. 7, the processor 1810 is configured to implement functions of the processing unit 1710, and the interface circuit 1820 is configured to implement functions of the input/output unit 1720.

It may be understood that, the processor in embodiments of this application may be a central processing unit (central processing unit, CPU), or may be another general-purpose processor, a digital signal processor (digital signal processor, DSP), an application-specific integrated circuit (application-specific integrated circuit, ASIC), a field programmable gate array (field programmable gate array, FPGA) or another programmable logic device, a transistor logic device, a hardware component, or any combination thereof. The general-purpose processor may be a microprocessor or any regular processor.

The method steps in embodiments of this application may be implemented in a hardware manner, or may be implemented in a manner of executing software instructions by the processor. The software instructions may include a corresponding software module. The software module may be stored in a random access memory, a flash memory, a read-only memory, a programmable read-only memory, an erasable programmable read-only memory, an electrically erasable programmable read-only memory, a register, a hard disk, a removable hard disk, a CD-ROM, or any other form of storage medium well-known in the art. For example, a storage medium is coupled to a processor, so that the processor can read information from the storage medium and write information into the storage medium. Certainly, the storage medium may be a component of the processor. The processor and the storage medium may be disposed in an ASIC. In addition, the ASIC may be located in a network device or a terminal device. Certainly, the processor and the storage medium may alternatively exist as discrete components in a network device or a terminal device.

All or a part of the foregoing embodiments may be implemented by software, hardware, firmware, or any combination thereof. When software is used to implement embodiments, all or a part of embodiments may be implemented in a form of a computer program product. The computer program product includes one or more computer programs or instructions. When the computer programs or instructions are loaded and executed on a computer, the procedures or functions in embodiments of this application are all or partially performed. The computer may be a general-purpose computer, a dedicated computer, a computer network, a network device, user equipment, or another programmable apparatus. The computer program or instructions may be stored in a computer-readable storage medium, or may be sent from a computer-readable storage medium to another computer-readable storage medium. For example, the computer program or instructions may be sent from a website, computer, server, or data center to another website, computer, server, or data center in a wired or wireless manner. The computer-readable storage medium may be any usable medium that can be accessed by the computer, or a data storage device, for example, a server or a data center, integrating one or more usable media. The usable medium may be a magnetic medium, for example, a floppy disk, a hard disk, or a magnetic tape; or may be an optical medium, for example, a digital video disc; or may be a semiconductor medium, for example, a solid-state drive. The computer-readable storage medium may be a volatile or non-volatile storage medium, or may include two types of storage media: a volatile storage medium and a non-volatile storage medium.

In various embodiments of this application, unless otherwise stated or there is a logic conflict, terms and/or descriptions in different embodiments are consistent and may be mutually referenced, and technical features in different embodiments may be combined based on an internal logical relationship thereof, to form a new embodiment.

In addition, it should be understood that the term "for example" in embodiments of this application is used to represent giving an example, an illustration, or a description. Any embodiment or design solution described as an "example" in this application should not be explained as being more preferred or having more advantages than another embodiment or design solution. Exactly, the word "for example" is used to present a concept in a specific manner.

In addition, in embodiments of this application, information (information), a signal (signal), a message (message), and a channel (channel) may be interchangeably used sometimes. It should be noted that meanings expressed by the terms are consistent when differences of the terms are not emphasized. Terms "of (of)", "relevant (corresponding, relevant)", and "corresponding (corresponding)" may sometimes be interchangeably used. It should be noted that meanings expressed by the terms are consistent when differences of the terms are not emphasized.

It may be understood that various numbers in embodiments of this application are merely used for differentiation for ease of description, and are not used to limit the scope of embodiments of this application. Sequence numbers of the foregoing processes do not mean an execution sequence, and the execution sequence of the processes should be determined based on functions and internal logic of the processes.

**Claims**

1. An encoding method, comprising:

   obtaining an information bit sequence;
   encoding the information bit sequence based on a systematic polar code, to determine an encoded bit sequence, wherein the systematic polar code comprises a polarization transformation matrix and N first bit positions and N second bit positions that correspond to the polarization transformation matrix, the N second bit positions comprise a systematic bit position set A and a non-systematic bit position set $M^A$, the N first bit positions comprise a frozen bit position set B and a non-frozen bit position set $M^B$, there is a frozen bit position subset C in B, there is a non-frozen bit position subset D in $M^B$, a frozen bit position in C and a non-frozen bit position in D are mapped to each other, C is determined based on a bit position index intersection set of B and A, D is determined based on a bit position index intersection set of $M^B$ and $M^A$, A is determined based on the information bit sequence, and the encoded bit sequence comprises the information bit sequence; and outputting the encoded bit sequence.

2. The method according to claim 1, wherein A comprises last K second bit positions in the N second bit positions; and/or
   B comprises N-K first bit positions selected from the N first bit positions based on channel reliability or codeword weights, wherein K is greater than or equal to 1 and less than N.

3. The method according to claim 1 or 2, wherein the encoding the information bit sequence based on a systematic polar code, to determine an encoded bit sequence comprises:

   determining a first intermediate encoded bit sequence based on the information bit sequence and a first polarization transformation submatrix, wherein the first polarization transformation submatrix is a polarization transformation submatrix that corresponds to A and that is in the polarization transformation matrix;
   determining a second intermediate encoded bit sequence based on the first intermediate encoded bit sequence, a mutual mapping relationship between the frozen bit position in C and the non-frozen bit position in D, and a bit position index intersection set of B and $M^A$, wherein a length of the second intermediate encoded bit sequence is equal to a quantity of second bit positions comprised in $M^A$; and
   determining the encoded bit sequence based on the second intermediate encoded bit sequence, a second polarization transformation submatrix, and the information bit sequence, wherein the second polarization transformation submatrix is a polarization transformation submatrix that corresponds to $M^A$ and that is in the polarization transformation matrix.

4. The method according to any one of claims 1 to 3, wherein the systematic polar code is concatenated with a

precoding matrix, and the precoding matrix is an upper triangular matrix $\begin{bmatrix} TA & TB \\ 0 & TC \end{bmatrix}$, wherein a quantity of rows of $TA$ and a quantity of rows of $TB$ are determined based on a quantity of non-systematic bit positions in $M^A$, a quantity of rows of $TC$ is determined based on a quantity of systematic bit positions in A, a quantity of columns of $TA$ is determined based on the quantity of non-systematic bit positions in $M^A$, and a quantity of columns of $TB$ and a quantity of columns of $TC$ are determined based on the quantity of systematic bit positions in A; and the encoding the information bit sequence based on a systematic polar code, to determine an encoded bit sequence comprises:

> determining the first intermediate encoded bit sequence based on the information bit sequence and the first polarization transformation submatrix, wherein the first polarization transformation submatrix is the polarization transformation submatrix that corresponds to A and that is in the polarization transformation matrix;
> determining a third intermediate encoded bit sequence based on the first intermediate encoded bit sequence, $TC$, and $TB$;
> determining a fourth intermediate encoded bit sequence based on the third intermediate encoded bit sequence, the mutual mapping relationship between the frozen bit position in C and the non-frozen bit position in D, and the bit position index intersection set of B and $M^A$;
> determining the second intermediate encoded bit sequence based on the fourth intermediate encoded bit sequence and $TA$; and
> determining the encoded bit sequence based on the second intermediate encoded bit sequence, the second polarization transformation submatrix, and the information bit sequence, wherein the second polarization transformation submatrix is the polarization transformation submatrix that corresponds to $M^A$ and that is in the polarization transformation matrix.

**5.** The method according to claim 3 or 4, wherein that A is determined based on the information bit sequence comprises:
A comprises a position of an information bit and a position of a cyclic redundancy check CRC bit corresponding to the information bit.

**6.** The method according to claim 5, wherein the first intermediate encoded bit sequence comprises a fifth intermediate encoded bit sequence and the CRC bit, the fifth intermediate encoded bit sequence is determined based on the information bit sequence and the first polarization transformation submatrix, and the CRC bit is determined based on the fifth intermediate encoded bit sequence.

**7.** The method according to any one of claims 1 to 6, wherein that the frozen bit position in C and the non-frozen bit position in D are mapped to each other comprises: the frozen bit position in C and the non-frozen bit position in D are mapped to each other based on a mapping matrix, wherein the mapping matrix is an $N_C$-dimensional full-rank matrix or an $N_C$-dimensional identity matrix, and $N_C$ is equal to a quantity of frozen bit positions in C.

**8.** A decoding method, comprising:

> obtaining a to-be-decoded symbol sequence; and
> decoding the to-be-decoded symbol sequence based on a systematic polar code, to determine an information bit sequence, wherein the systematic polar code comprises a polarization transformation matrix and N first bit positions and N second bit positions that correspond to the polarization transformation matrix, the N second bit positions comprise a systematic bit position set A and a non-systematic bit position set $M^A$, the N first bit positions comprise a frozen bit position set B and a non-frozen bit position set $M^B$, there is a frozen bit position subset C in B, there is a non-frozen bit position subset D in $M^B$, a frozen bit position in C and a non-frozen bit position in D are mapped to each other, C is determined based on a bit position index intersection set of B and A, D is determined based on a bit position index intersection set of $M^B$ and $M^A$, and A is determined based on the information bit sequence.

**9.** The method according to claim 8, wherein A comprises last K second bit positions in the N second bit positions; and/or
B comprises N-K first bit positions selected from the N first bit positions based on channel reliability or codeword weights, wherein K is greater than or equal to 1 and less than N.

**10.** The method according to claim 8 or 9, wherein the decoding the to-be-decoded symbol sequence based on a systematic polar code, to determine an information bit sequence comprises:

determining a first intermediate decoded bit sequence based on the to-be-decoded symbol sequence, the polarization transformation matrix, a mutual mapping relationship between the frozen bit position in C and the non-frozen bit position in D, and a bit position index intersection set of B and $M^A$; and

determining the information bit sequence based on the first intermediate decoded bit sequence and the polarization transformation matrix.

11. The method according to claim 10, wherein that A is determined based on the information bit sequence comprises:

A comprises a position of an information bit and a position of a cyclic redundancy check CRC bit corresponding to the information bit.

12. The method according to claim 11, wherein the first intermediate decoded bit sequence comprises a second intermediate decoded bit sequence and the CRC bit, the CRC bit is used to check the second intermediate decoded bit sequence, the second intermediate decoded bit sequence corresponds to the position of the information bit, and the CRC bit corresponds to the position of the CRC bit.

13. The method according to any one of claims 8 to 12, wherein that the frozen bit position in C and the non-frozen bit position in D are mapped to each other comprises: the frozen bit position in C and the non-frozen bit position in D are mapped to each other based on a mapping matrix, wherein the mapping matrix is an $N_C$-dimensional full-rank matrix or an $N_C$-dimensional identity matrix, and $N_C$ is equal to a quantity of frozen bit positions in C.

14. A communication apparatus, comprising an input/output unit and a processing unit, wherein

the input/output unit is configured to obtain an information bit sequence;
the processing unit is configured to encode the information bit sequence based on a systematic polar code, to determine an encoded bit sequence, wherein the systematic polar code comprises a polarization transformation matrix and N first bit positions and N second bit positions that correspond to the polarization transformation matrix, the N second bit positions comprise a systematic bit position set A and a non-systematic bit position set $M^A$, the N first bit positions comprise a frozen bit position set B and a non-frozen bit position set $M^B$, there is a frozen bit position subset C in B, there is a non-frozen bit position subset D in $M^B$, a frozen bit position in C and a non-frozen bit position in D are mapped to each other, C is determined based on a bit position index intersection set of B and A, D is determined based on a bit position index intersection set of $M^B$ and $M^A$, A is determined based on the information bit sequence, and the encoded bit sequence comprises the information bit sequence; and

the input/output unit is further configured to output the encoded bit sequence.

15. The apparatus according to claim 14, wherein A comprises last K second bit positions in the N second bit positions; and/or

B comprises N-K first bit positions selected from the N first bit positions based on channel reliability or codeword weights, wherein K is greater than or equal to 1 and less than N.

16. The apparatus according to claim 14 or 15, wherein when encoding the information bit sequence based on the systematic polar code, to determine the encoded bit sequence, the processing unit is specifically configured to determine a first intermediate encoded bit sequence based on the information bit sequence and a first polarization transformation submatrix, wherein the first polarization transformation submatrix is a polarization transformation submatrix that corresponds to A and that is in the polarization transformation matrix; determine a second intermediate encoded bit sequence based on the first intermediate encoded bit sequence, a mutual mapping relationship between the frozen bit position in C and the non-frozen bit position in D, and a bit position index intersection set of B and $M^A$, wherein a length of the second intermediate encoded bit sequence is equal to a quantity of second bit positions comprised in $M^A$; and determine the encoded bit sequence based on the second intermediate encoded bit sequence, a second polarization transformation submatrix, and the information bit sequence, wherein the second polarization transformation submatrix is a polarization transformation submatrix that corresponds to $M^A$ and that is in the polarization transformation matrix.

17. The apparatus according to any one of claims 14 to 16, wherein the systematic polar code is concatenated

with a precoding matrix, and the precoding matrix is an upper triangular matrix $\begin{bmatrix} TA & TB \\ 0 & TC \end{bmatrix}$, wherein a quantity of rows of TA and a quantity of rows of TB are determined based on a quantity of non-systematic bit positions in $M^A$, a quantity of rows of TC is determined based on a quantity of systematic bit positions in A, a quantity of columns of TA is determined based on the quantity of non-systematic bit positions in $M^A$, and a quantity of columns of *TB* and a quantity of columns of *TC* are determined based on the quantity of systematic bit positions in A; and when encoding the information bit sequence based on the systematic polar code, to determine the encoded bit sequence, the processing unit is specifically configured to determine the first intermediate encoded bit sequence based on the information bit sequence and the first polarization transformation submatrix, wherein the first polarization transformation submatrix is the polarization transformation submatrix that corresponds to A and that is in the polarization transformation matrix; determine a third intermediate encoded bit sequence based on the first intermediate encoded bit sequence, *TC,* and *TB;* determine a fourth intermediate encoded bit sequence based on the third intermediate encoded bit sequence, the mutual mapping relationship between the frozen bit position in C and the non-frozen bit position in D, and the bit position index intersection set of B and $M^A$; determine the second intermediate encoded bit sequence based on the fourth intermediate encoded bit sequence and *TA*; and determine the encoded bit sequence based on the second intermediate encoded bit sequence, the second polarization transformation submatrix, and the information bit sequence, wherein the second polarization transformation submatrix is the polarization transformation submatrix that corresponds to $M^A$ and that is in the polarization transformation matrix.

18. The apparatus according to claim 16 or 17, wherein that A is determined based on the information bit sequence comprises:
A comprises a position of an information bit and a position of a cyclic redundancy check CRC bit corresponding to the information bit.

19. The apparatus according to claim 18, wherein the first intermediate encoded bit sequence comprises a fifth intermediate encoded bit sequence and the CRC bit, the fifth intermediate encoded bit sequence is determined based on the information bit sequence and the first polarization transformation submatrix, and the CRC bit is determined based on the fifth intermediate encoded bit sequence.

20. The apparatus according to any one of claims 14 to 19, wherein that the frozen bit position in C and the non-frozen bit position in D are mapped to each other comprises: the frozen bit position in C and the non-frozen bit position in D are mapped to each other based on a mapping matrix, wherein the mapping matrix is an $N_C$-dimensional full-rank matrix or an

$N_C$-dimensional identity matrix, and $N_C$ is equal to a quantity of frozen bit positions in C.

21. A communication apparatus, comprising an input/output unit and a processing unit, wherein

the input/output unit is configured to obtain a to-be-decoded symbol sequence; and
the processing unit is configured to decode the to-be-decoded symbol sequence based on a systematic polar code, to determine an information bit sequence, wherein the systematic polar code comprises a polarization transformation matrix and N first bit positions and N second bit positions that correspond to the polarization transformation matrix, the N second bit positions comprise a systematic bit position set A and a non-systematic bit position set $M^A$, the N first bit positions comprise a frozen bit position set B and a non-frozen bit position set $M^B$, there is a frozen bit position subset C in B, there is a non-frozen bit position subset D in $M^B$, a frozen bit position in C and a non-frozen bit position in D are mapped to each other, C is determined based on a bit position index intersection set of B and A, D is determined based on a bit position index intersection set of $M^B$ and $M^A$, and A is determined based on the information bit sequence.

22. The apparatus according to claim 21, wherein A comprises last K second bit positions in the N second bit positions; and/or
B comprises N-K first bit positions selected from the N first bit positions based on channel reliability or codeword weights, wherein K is greater than or equal to 1 and less than N.

23. The apparatus according to claim 21 or 22, wherein when decoding the to-be-decoded symbol sequence based on the systematic polar code, to determine the information bit sequence, the processing unit is specifically configured to determine a first intermediate decoded bit sequence based on the to-be-decoded symbol sequence, the polarization transformation matrix, a mutual mapping relationship between the frozen bit position in C and the non-frozen bit position in D, and a bit position index intersection set of B and $M^A$; and determine the information bit sequence based on the first intermediate decoded bit sequence and the polarization transformation matrix.

24. The apparatus according to claim 23, wherein that A is determined based on the information bit sequence comprises: A comprises a position of an information bits and a position of a cyclic redundancy check CRC bit corresponding to the information bit.

25. The apparatus according to claim 24, wherein the first intermediate decoded bit sequence comprises a second intermediate decoded bit sequence and the CRC bit, the CRC bit is used to check the second intermediate decoded bit sequence, the second intermediate decoded bit sequence corresponds to the position of the information bit, and the CRC bit corresponds to the position of the CRC bit.

26. The apparatus according to any one of claims 21 to 25, wherein that the frozen bit position in C and the non-frozen bit position in D are mapped to each other comprises: the frozen bit position in C and the non-frozen bit position in D are mapped to each other based on a mapping matrix, wherein the mapping matrix is an $N_C$-dimensional full-rank matrix or an $N_C$-dimensional identity matrix, and $N_C$ is equal to a quantity of frozen bit positions in C.

27. A communication apparatus, comprising a processor and an interface circuit, wherein the interface circuit is configured to receive a signal from a communication apparatus other than the communication apparatus and send the signal to the processor, or send a signal from the processor to a communication apparatus other than the communication apparatus, and the processor is configured to implement the method according to any one of claims 1 to 7 or the method according to any one of claims 8 to 13 through a logic circuit or by executing code instructions.

28. A computer program product, comprising a program code, wherein when the program code is executed, the method according to any one of claims 1 to 7 or the method according to any one of claims 8 to 13 is implemented.

29. A chip, wherein the chip is configured to implement the method according to any one of claims 1 to 7 or the method according to any one of claims 8 to 13.

30. A computer-readable storage medium, wherein the storage medium stores a computer program or instructions, and when the computer program or the instructions are executed, the method according to any one of claims 1 to 7 or the method according to any one of claims 8 to 13 is implemented.

31. A communication system, wherein the communication system comprises an encoding device and a decoding device, wherein

the encoding device is configured to implement the method according to any one of claims 1 to 7; and
the decoding device is configured to implement the method according to any one of claims 8 to

13.

FIG. 1

FIG. 2

FIG. 3

FIG. 4

| Frozen bit position | Systematic bit position | Check bit position |

FIG. 5

FIG. 6

Encoding device

Decoding device

S701: The encoding device obtains an information bit sequence

S702: The encoding device encodes the information bit sequence based on a systematic polar code, to determine an encoded bit sequence

S703: The encoding device outputs the encoded bit sequence, and correspondingly, the decoding device obtains a to-be-decoded symbol sequence

S704: The decoding device decodes the to-be-decoded symbol sequence based on the systematic polar code, to determine the information bit sequence

FIG. 7

FIG. 8

$$C=X_2G_2+U$$

$$X_1=UG_1$$

Frozen bit position

Systematic bit position

Check bit position (non-systematic bit position)

FIG. 9

| Precoding matrix (pre-transformation) | Polarization transformation matrix (polarization transformation) |

FIG. 10

FIG. 11

$C = X_2G_2 + U$

$X_1 = UG_1$

- Frozen bit position
- Systematic bit position
- Check bit position (non-systematic bit position)

FIG. 12

FIG. 13

EP 4 531 287 A1

FIG. 14

FIG. 15

FIG. 16

FIG. 17

Communication apparatus 1800

Processor 1810

Interface circuit 1820

Memory 1830

FIG. 18

## INTERNATIONAL SEARCH REPORT

| International application No. |
| --- |
| **PCT/CN2023/091491** |

**A.    CLASSIFICATION OF SUBJECT MATTER**

H03M 13/13(2006.01)i

According to International Patent Classification (IPC) or to both national classification and IPC

**B.    FIELDS SEARCHED**

Minimum documentation searched (classification system followed by classification symbols)

H03M

Documentation searched other than minimum documentation to the extent that such documents are included in the fields searched

Electronic data base consulted during the international search (name of data base and, where practicable, search terms used)

VEN, ENTXT, IEEE, CNABS, CNTXT, CNKI: 编码, 译码, 系统极化码, 映射, 冻结, 系统, 索引, 比特位, 矩阵, encoding, coding, systematic polar codes, mapping, freeze, systematic, index, bit, matrix

**C.    DOCUMENTS CONSIDERED TO BE RELEVANT**

| Category* | Citation of document, with indication, where appropriate, of the relevant passages | Relevant to claim No. |
| --- | --- | --- |
| A | CN 113162634 A (SUN YAT-SEN UNIVERSITY) 23 July 2021 (2021-07-23) description, paragraphs 3-28 | 1-31 |
| A | CN 110495106 A (HUAWEI TECHNOLOGIES DUESSELDORF GMBH et al.) 22 November 2019 (2019-11-22) entire document | 1-31 |
| A | CN 111800172 A (HUAWEI TECHNOLOGIES CO., LTD.) 20 October 2020 (2020-10-20) entire document | 1-31 |
| A | CN 112886969 A (HUAWEI TECHNOLOGIES CO., LTD.) 01 June 2021 (2021-06-01) entire document | 1-31 |
| A | US 2018248567 A1 (HUAZHONG UNIVERSITY OF SCIENCE AND TECHNOLOGY) 30 August 2018 (2018-08-30) entire document | 1-31 |

☐ Further documents are listed in the continuation of Box C.      ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **13 June 2023** | **16 June 2023** |

| Name and mailing address of the ISA/CN | Authorized officer |
| --- | --- |
| **China National Intellectual Property Administration (ISA/ CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

International application No.

**PCT/CN2023/091491**

| Patent document cited in search report | | | Publication date (day/month/year) | Patent family member(s) | | | Publication date (day/month/year) |
|---|---|---|---|---|---|---|---|
| CN | 113162634 | A | 23 July 2021 | CN | 113162634 | B | 20 January 2023 |
| CN | 110495106 | A | 22 November 2019 | US | 2020052718 | A1 | 13 February 2020 |
| | | | | US | 11108411 | B2 | 31 August 2021 |
| | | | | EP | 3602796 | A1 | 05 February 2020 |
| | | | | WO | 2018192640 | A1 | 25 October 2018 |
| CN | 111800172 | A | 20 October 2020 | WO | 2020207254 | A1 | 15 October 2020 |
| | | | | CN | 111800172 | B | 25 February 2022 |
| CN | 112886969 | A | 01 June 2021 | WO | 2021103978 | A1 | 03 June 2021 |
| | | | | EP | 4050826 | A1 | 31 August 2022 |
| | | | | US | 2022286144 | A1 | 08 September 2022 |
| | | | | EP | 4050826 | A4 | 21 December 2022 |
| US | 2018248567 | A1 | 30 August 2018 | EP | 3364542 | A1 | 22 August 2018 |
| | | | | EP | 3364542 | A4 | 03 April 2019 |
| | | | | WO | 2017107761 | A1 | 29 June 2017 |
| | | | | CN | 105680883 | A | 15 June 2016 |
| | | | | CN | 105680883 | B | 14 November 2017 |

Form PCT/ISA/210 (patent family annex) (July 2022)

**REFERENCES CITED IN THE DESCRIPTION**

**Patent documents cited in the description**

- CN 202210566961